# EUROPEAN PATENT APPLICATION

(11) **EP 3 905 330 A1**
(43) Date of publication of application: **03.11.2021**
(21) Application number: 19904347.2
(22) Date of filing: 22.11.2019
(51) Int. Cl.: H01L 27/146, G02B 5/20, H01L 31/0232, H04N 5/369, H04N 9/07

(54) **IMAGING ELEMENT AND METHOD FOR MANUFACTURING IMAGING ELEMENT**

(30) Priority: 27.12.2018 JP 2018244434
(71) Applicant: Sony Semiconductor Solutions Corporation, Atsugi-shi, Kanagawa 243-0014 (JP)
(72) Inventor: TANAKA Yoshikazu, Kikuchi-gun, Kumamoto 869-1102 (JP); OHBA Nobuyuki, Kikuchi-gun, Kumamoto 869-1102 (JP); NAKAJIKI Sintaro, Kikuchi-gun, Kumamoto 869-1102 (JP); SAYAMA Yukihiro, Kikuchi-gun, Kumamoto 869-1102 (JP); OHKUBO Yuka, Kikuchi-gun, Kumamoto 869-1102 (JP); NISHIYAMA Tsubasa, Kikuchi-gun, Kumamoto 869-1102 (JP); NISHIKIDO Kenju, Kikuchi-gun, Kumamoto 869-1102 (JP); HAGIHARA Yousuke, Kikuchi-gun, Kumamoto 869-1102 (JP)
(74) Representative: MFG Patentanwälte Meyer-Wildhagen Meggle-Freund Gerhard PartG mbB
(86) International application number: PCT/JP2019/045777
(87) International publication number: WO 2020/137285

(57) **Abstract**

A light-shielding body that shields incident light from an adjacent pixel is easily formed even in a case where the pixel is made finer.

An imaging element is provided with a photoelectric conversion unit, an insulating film, an incident light transmitting film, and a light-shielding body. The photoelectric conversion unit is formed in a semiconductor substrate to perform photoelectric conversion of incident light from a subject and is arranged in a plurality of pixels. The insulating film is arranged on a plurality of pixels to insulate the semiconductor substrate. The incident light transmitting film is arranged adjacent to the insulating film of the plurality of pixels and transmits the incident light. The light-shielding body is arranged in a groove formed in the incident light transmitting film on a peripheral edge of each of the plurality of pixels to shield the incident light.

## Description

### TECHNICAL FIELD

The present disclosure relates to an imaging element and a manufacturing method of the imaging element. Specifically, this relates to an imaging element provided with a pixel on which a light-shielding film is arranged, and a manufacturing method of the imaging element.

### BACKGROUND ART

Conventionally, as an imaging element, an imaging element in which a light-shielding film is arranged on a peripheral edge of a pixel is used. By arranging this light-shielding film, it is possible to shield light obliquely incident from an adjacent pixel. It is possible to prevent occurrence of color mixing that causes noise in an image signal due to mixing of incident light of a different color transmitted through a color filter of the adjacent pixel. As such imaging element, for example, an imaging element that uses a film of a metal material formed on a surface of an insulating film arranged adjacent to a semiconductor substrate as a light-shielding film is used (refer to, for example, Patent Document 1). In this imaging element, the light-shielding film is formed at the following steps. First, a film of a metal material is formed on an insulating film. Next, a region other than a peripheral edge of each pixel of the film of the metal material is etched and removed. At these steps, the light-shielding film is formed on the peripheral edge of the pixel.

### CITATION LIST

### PATENT DOCUMENT

Patent Document 1: International Publication No. 2016/114154

### SUMMARY OF THE INVENTION

### PROBLEMS TO BE SOLVED BY THE INVENTION

The above-described conventional technology has a problem that it becomes difficult to form the light-shielding film as the pixel is made finer. When the pixel is made finer with higher definition of the imaging element, it becomes necessary to reduce a size of the light-shielding film. In such a case, the above-described conventional technology has a problem that it becomes difficult to form the light-shielding film.

The present disclosure is achieved in view of the above-described problems, and an object thereof is to easily form a light-shielding film even in a case where the pixel is made finer.

### SOLUTIONS TO PROBLEMS

The present disclosure is achieved for solving the above-described problems, and a first aspect thereof is an imaging element provided with a plurality of pixels in each of which a photoelectric conversion unit that is formed in a semiconductor substrate and photoelectrically converts incident light from a subject is arranged, an insulating film that is arranged on the plurality of pixels and insulates the semiconductor substrate, an incident light transmitting film that is arranged adjacent to the insulating film of the plurality of pixels and transmits incident light, and a light-shielding body that is arranged in a groove formed in the incident light transmitting film on a peripheral edge of each of the plurality of pixels and shields the incident light.

Furthermore, in this first aspect, the groove may be formed by etching the incident light transmitting film.

Furthermore, in this first aspect, the insulating film may be used as a film that stops progress of etching when etching the incident light transmitting film.

Furthermore, in this first aspect, a light-shielding film that is arranged adjacent to the incident light transmitting film and shields the incident light may further be provided.

Furthermore, in this first aspect, the light-shielding film may be arranged on a pixel on a peripheral edge out of the plurality of pixels.

Furthermore, in this first aspect, a phase difference pixel being a pixel for detecting a phase difference by pupil-splitting the incident light from the subject may further be provided, in which the light-shielding film may be arranged on the phase difference pixel and shield a part of the incident light according to a pupil-splitting direction.

Furthermore, in this first aspect, a second light-shielding body that is arranged in a groove formed in the incident light transmitting film near an end of the light-shielding film and shields diffracted light of the incident light may further be provided.

Furthermore, in this first aspect, the light-shielding body may be formed into a tapered shape.

Furthermore, a second aspect of the present disclosure is a manufacturing method of an imaging element, provided with a step of forming a photoelectric conversion unit that is arranged for each of a plurality of pixels and photoelectrically converts incident light from a subject in a semiconductor substrate, a step of arranging an insulating film that is arranged on the plurality of pixels and insulates the semiconductor substrate, a step of arranging an incident light transmitting film that is arranged adjacent to the insulating film of the plurality of pixels and transmits the incident light, a step of forming a groove in the incident light transmitting film on a peripheral edge of each of the plurality of pixels, and a step of arranging a light-shielding body that shields the incident light in the formed groove.

By adopting the above-described aspect, an effect that the light-shielding body is embedded to be arranged in the groove formed in the peripheral edge of the incident light transmitting film is obtained. It is assumed to omit processing steps such as etching for patterning the light-shielding body.

Furthermore, a third aspect of the present disclosure is an imaging element provided with a plurality of pixels in each of which a photoelectric conversion unit that is formed in a semiconductor substrate and photoelectrically converts incident light from a subject is arranged, a color filter that is arranged on the plurality of pixels and allows incident light of a predetermined wavelength out of the incident light to be incident on the photoelectric conversion unit, a first color filter unit light-shielding layer that is arranged on the plurality of pixels and shields the incident light, the color filter is arranged in an opening formed in a central portion of the first color filter unit light-shielding layer, and a second color filter unit light-shielding layer that is arranged on the plurality of pixels and shields the incident light, the color filter is arranged in an opening formed in a central portion of the second color filter unit light-shielding layer, the second color filter unit light-shielding layer arranged between the first color filter unit light-shielding layer and the semiconductor substrate.

Furthermore, in the third aspect, the first color filter unit light-shielding layer and the second color filter unit light-shielding layer may include different materials.

Furthermore, in the third aspect, the first color filter unit light-shielding layer may include resin, and the second color filter unit light-shielding layer may include metal.

Furthermore, in the third aspect, the first color filter unit light-shielding layer may have transmissivity of 30% or lower.

Furthermore, in the third aspect, an interlayer film arranged between the first color filter unit light-shielding layer and the second color filter unit light-shielding layer of the plurality of pixels may further be provided.

Furthermore, in the third aspect, the interlayer film may include an inorganic material.

Furthermore, in the third aspect, the second color filter unit light-shielding layer may be formed to have a larger width than a width of the first color filter unit light-shielding layer.

Furthermore, in the third aspect, a flattening film that is arranged between the color filter of the plurality of pixels and the semiconductor substrate and flattens a surface of the semiconductor substrate, and a light-shielding wall that is arranged around the flattening film on the plurality of pixels and shields the incident light may further be provided.

Furthermore, in the third aspect, a second interlayer film arranged between the second color filter unit light-shielding layer and the light-shielding wall of the plurality of pixels may further be provided.

Furthermore, in the third aspect, the second interlayer film may include an inorganic material.

Furthermore, in the third aspect, the second color filter unit light-shielding layer may be formed to have a larger width than a width of the light-shielding wall.

Furthermore, in the third aspect, at least one of the first color filter unit light-shielding layer or the second color filter unit light-shielding layer in a pixel arranged on a peripheral edge out of the plurality of pixels may be formed into a shape to shield light on an entire surface of the pixel.

Furthermore, in the third aspect, at least one of the first color filter unit light-shielding layer or the second color filter unit light-shielding layer may be formed into a tapered shape.

Furthermore, a fourth aspect of the present disclosure is a manufacturing method of an imaging element, provided with
a step of forming a photoelectric conversion unit that is arranged for each of a plurality of pixels and photoelectrically converts incident light from a subject in a semiconductor substrate, a step of arranging a second color filter unit light-shielding layer that is arranged on the plurality of pixels and shields the incident light on the semiconductor substrate, a color filter that allows incident light of a predetermined wavelength out of the incident light to be incident on the photoelectric conversion unit is arranged in an opening formed in a central portion of the second color filter unit light-shielding layer, a step of stacking and arranging a first color filter unit light-shielding layer that is arranged on the plurality of pixels and shields the incident light on the second color filter unit light-shielding layer, the color filter is arranged in an opening formed in a central portion of the first color filter unit light-shielding layer, and a step of arranging the color filter in the opening of each of the second color filter unit light-shielding layer and the first color filter unit light-shielding layer of the plurality of pixels.

By adopting the above-described aspect, an effect that the first color filter unit light-shielding layer and the second color filter unit light-shielding layer are arranged in the same layer as the color filter is obtained. It is assumed to shield the incident light incident via the adjacent pixel and the like on the color filter unit.

### BRIEF DESCRIPTION OF DRAWINGS

Fig. 1 is a view illustrating a configuration example of an imaging device according to an embodiment of the present disclosure.
Fig. 2 is a view illustrating a configuration example of a pixel array unit according to the embodiment of the present disclosure.
Fig. 3 is a view illustrating an example of light shielding of pixels according to a first embodiment of the present disclosure.
Fig. 4 is a view illustrating a configuration example of a pixel according to the first embodiment of the present disclosure.
Fig. 5 is a view illustrating an example of a manufacturing method of the pixel array unit according to the first embodiment of the present disclosure.
Fig. 6 is a view illustrating an example of the manufacturing method of the pixel array unit according to the first embodiment of the present disclosure.
Fig. 7 is a view illustrating an example of the manufacturing method of the pixel array unit according to the first embodiment of the present disclosure.
Fig. 8 is a view illustrating a configuration example of a pixel according to a conventional imaging element.
Fig. 9 is a view illustrating a configuration example of a pixel according to a second embodiment of the present disclosure.
Fig. 10 is a view illustrating a configuration example of a pixel according to a third embodiment of the present disclosure.
Fig. 11 is a view illustrating a configuration example of a pixel according to a fourth embodiment of the present disclosure.
Fig. 12 is a view illustrating an example of a manufacturing method of a pixel array unit according to the fourth embodiment of the present disclosure.
Fig. 13 is a view illustrating an example of the manufacturing method of a pixel array unit according to the fourth embodiment of the present disclosure.
Fig. 14 is a view illustrating an example of the manufacturing method of a pixel array unit according to the fourth embodiment of the present disclosure.
Fig. 15 is a view illustrating an example of the manufacturing method of a pixel array unit according to the fourth embodiment of the present disclosure.
Fig. 16 is a view illustrating a configuration example of a pixel according to a fifth embodiment of the present disclosure.
Fig. 17 is a view illustrating a configuration example of a pixel according to a sixth embodiment of the present disclosure.
Fig. 18 is a view illustrating a configuration example of a pixel according to a seventh embodiment of the present disclosure.
Fig. 19 is a view illustrating a configuration example of a pixel according to an eighth embodiment of the present disclosure.
Fig. 20 is a view illustrating an outline of a configuration example of a stacked solid-state imaging device to which the technology according to the present disclosure is applicable.
Fig. 21 is a cross-sectional view illustrating a first configuration example of a stacked solid-state imaging device 23020.
Fig. 22 is a cross-sectional view illustrating a second configuration example of the stacked solid-state imaging device 23020.
Fig. 23 is a cross-sectional view illustrating a third configuration example of the stacked solid-state imaging device 23020.
Fig. 24 is a cross-sectional view illustrating another configuration example of a stacked solid-state imaging device to which the technology according to the present disclosure is applicable.
Fig. 25 is a block diagram illustrating a schematic configuration example of a camera that is an example of an imaging device to which the present technology may be applied.
Fig. 26 is a view illustrating an example of a schematic configuration of an endoscopic surgery system.
Fig. 27 is a block diagram illustrating an example of a functional configuration of a camera head and a CCU.
Fig. 28 is a block diagram illustrating an example of a schematic configuration of a vehicle control system.
Fig. 29 is an illustrative view illustrating an example of an installation position of a vehicle exterior information detection unit and an imaging unit.

### MODE FOR CARRYING OUT THE INVENTION

Next, modes for carrying out the present disclosure (hereinafter, referred to as embodiments) are described with reference to the drawings. In the following drawings, the same or similar parts are assigned with the same or similar reference signs. Furthermore, the embodiments are described in the following order.
1. First Embodiment
2. Second Embodiment
3. Third Embodiment
4. Fourth Embodiment
5. Fifth Embodiment
6. Sixth Embodiment
7. Seventh Embodiment
8. Eighth Embodiment
9. Application Example to Stacked Solid-state Imaging Device
10. Application Example to Camera
11. Application Example to Endoscopic Surgery System
12. Application Example to Mobile Body

### <1. First Embodiment>

### [Configuration of Imaging Device]

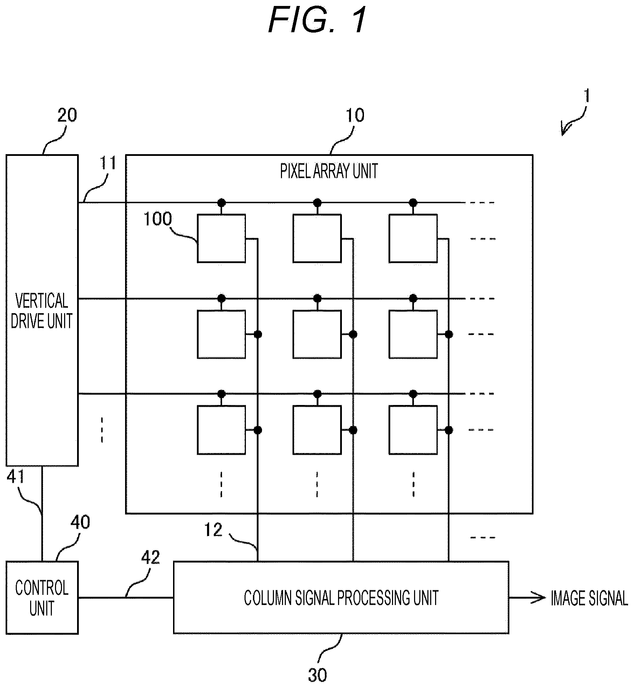

Fig. 1 is a view illustrating a configuration example of an imaging device according to an embodiment of the present disclosure. An imaging device 1 in the drawing is provided with a pixel array unit 10, a vertical drive unit 20, a column signal processing unit 30, and a control unit 40.

The pixel array unit 10 is formed by arranging pixels 100 in a two-dimensional lattice pattern. Here, the pixel 100 generates an image signal according to applied light. The pixel 100 includes a photoelectric conversion unit that generates electric charge according to the applied light. Furthermore, the pixel 100 further includes a pixel circuit. The pixel circuit generates an image signal based on the electric charge generated by the photoelectric conversion unit. Generation of the image signal is controlled by a control signal generated by the vertical drive unit 20 to be described later. In the pixel array unit 10, signal lines 11 and 12 are arranged in an XY matrix pattern. The signal line 11 being a signal line that transmits the control signal of the pixel circuit in the pixel 100 is arranged for each row of the pixel array unit 10 and is commonly wired to the pixels 100 arranged in each row. The signal line 12 being a signal line that transmits the image signal generated by the pixel circuit of the pixel 100 is arranged for each column of the pixel array unit 10 and is commonly wired to the pixels 100 arranged in each column. The photoelectric conversion unit and the pixel circuit are formed in a semiconductor substrate.

The vertical drive unit 20 generates the control signal of the pixel circuit of the pixel 100. The vertical drive unit 20 transmits the generated control signal to the pixel 100 via the signal line 11 in the drawing. The column signal processing unit 30 processes the image signal generated by the pixel 100. The column signal processing unit 30 processes the image signal transmitted from the pixel 100 via the signal line 12 in the drawing. The processing by the column signal processing unit 30 corresponds to, for example, analog-digital conversion to convert an analog image signal generated by the pixel 100 into a digital image signal. The image signal processed by the column signal processing unit 30 is output as the image signal of the imaging device 1. The control unit 40 controls an entire imaging device 1. The control unit 40 controls the imaging device 1 by generating and outputting the control signal that controls the vertical drive unit 20 and the column signal processing unit 30. The control signal generated by the control unit 40 is transmitted to the vertical drive unit 20 and the column signal processing unit 30 via signal lines 41 and 42, respectively.

Note that the pixel array unit 10 is an example of an imaging element recited in claims. Furthermore, the imaging device 1 may be made an imaging element in which the vertical drive unit 20 and the like is arranged.

### [Configuration of Imaging Element]

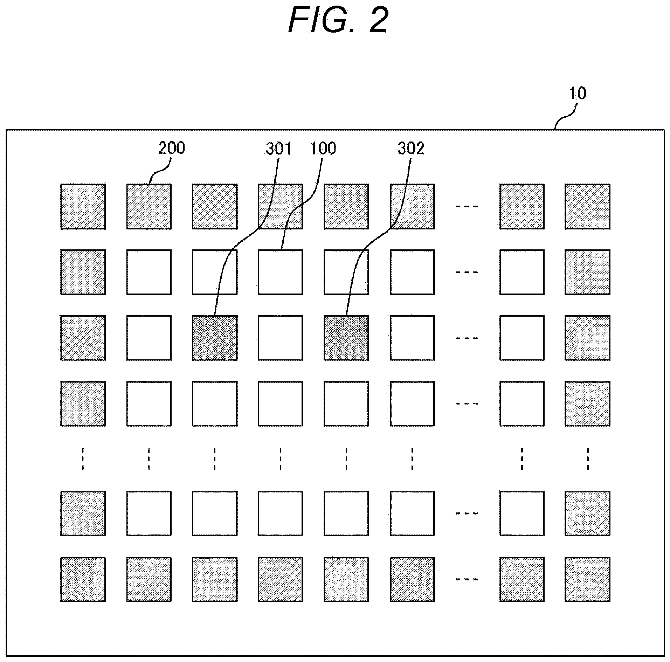

Fig. 2 is a view illustrating a configuration example of the pixel array unit according to the embodiment of the present disclosure. The pixel array unit 10 in the drawing is provided with a light-shielding pixel 200 and phase difference pixels 301 and 302 in addition to the pixel 100.

The light-shielding pixel 200 is a pixel arranged on a peripheral edge of the pixel array unit 10, the pixel that shields incident light. The light-shielding pixel 200 generates an image signal in a state in which the incident light is shielded. The generated image signal may be used to detect a black level. An example in which the light-shielding pixels 200 are arranged on an outermost periphery of a plurality of pixels is illustrated in the pixel array unit 10 in the drawing.

The phase difference pixels are pixels for detecting a phase difference by pupil-splitting a subject. It is possible to detect a focal position of the subject and perform autofocus by the detected phase difference. An example of the phase difference pixels 301 and 302 is illustrated in the pixel array unit 10 in the drawing. The phase difference pixels 301 and 302 are arranged in proximity to each other in a row (lateral) direction of the pixel array unit 10 and pupil-split the subject in the lateral direction. Configurations of the pixel 100, the light-shielding pixel 200, and the phase difference pixels 301 and 302 are described later in detail.

### [Light Shielding of Pixel]

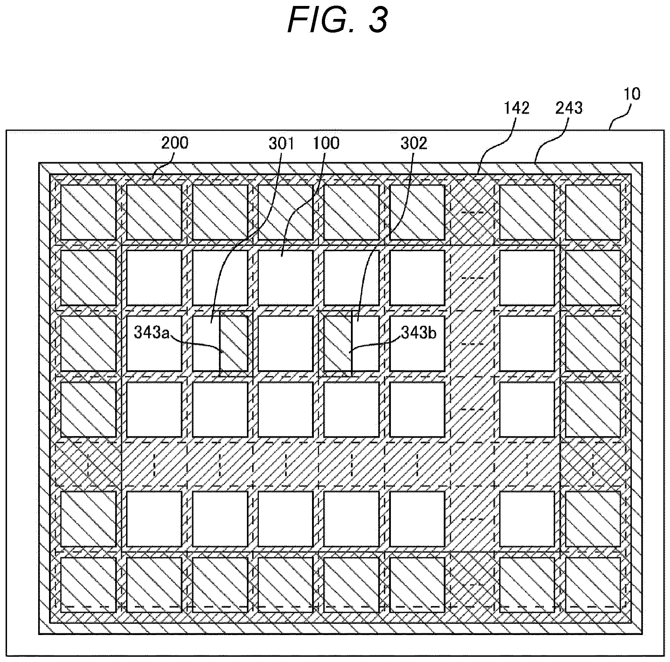

Fig. 3 is a view illustrating an example of light shielding of pixels according to a first embodiment of the present disclosure. The drawing illustrates an example of shielding the incident light on the pixel 100, the light-shielding pixel 200, and the phase difference pixels 301 and 302 of the pixel array unit 10. Dotted rectangles in the drawing represent the pixel 100, the light-shielding pixel 200, and the phase difference pixels 301 and 302. A region hatched with (right-upward) diagonal lines in the drawing represents a light-shielding body 142. The light-shielding body 142 is arranged on a peripheral edge of each pixel 100 and the like to shield the incident light. In the pixel 100 and the like, a region in which the light-shielding body 142 is not arranged serves as an opening of the light-shielding body 142 through which the incident light is transmitted.

Furthermore, a region hatched with (right-downward) diagonal lines in the drawing represents a region of a light-shielding film 243. The light-shielding film 243 shields the incident light as is the case with the light-shielding body 142. The light-shielding film 243 is formed in a layer different from that of the light-shielding body 142 and is arranged to cover an entire surface of the light-shielding pixels 200. Furthermore, light-shielding films 343a and 343b are arranged on the phase difference pixels 301 and 302, respectively. The light-shielding films 343a and 343b shield light on a right side of the phase difference pixel 301 and a left side of the phase difference pixel 302. That is, an opening of the light-shielding film is formed to the left of the light-shielding film 343a and to the right of the light-shielding film 343b. Therefore, light transmitted on a right side and a left side of an imaging lens that forms an image of the subject on the imaging device 1 is incident on the phase difference pixels 301 and 302, respectively. That is, the phase difference pixels 301 and 302 are pupil-split in a right and left direction of the pixel array unit 10. In this manner, the light-shielding films 343a and 343b are arranged according to a pupil-splitting direction of the phase difference pixels 301 and 302.

### [Configuration of Pixel]

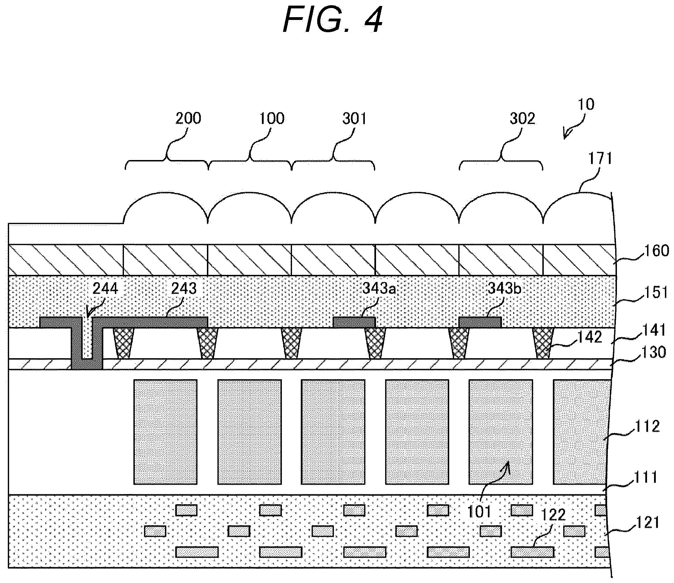

Fig. 4 is a view illustrating a configuration example of a pixel according to the first embodiment of the present disclosure. The drawing is a schematic cross-sectional view illustrating a configuration example of the pixel 100, the light-shielding pixel 200, and the phase difference pixels 301 and 302 arranged in the pixel array unit 10. The pixel 100 is provided with a semiconductor substrate 111, an insulating layer 121 and a wiring layer 122, an insulating film 130, an incident light transmitting film 141, the light-shielding body 142, a flattening film 151, a color filter 160, and an on-chip lens 171. Note that the insulating layer 121 and the wiring layer 122 form a wiring region.

The semiconductor substrate 111 is a semiconductor substrate in which semiconductor regions of elements forming the photoelectric conversion unit and the pixel circuit of the pixel 100 are formed. The semiconductor elements are formed in well regions formed in the semiconductor substrate. For convenience, the semiconductor substrate 111 in the drawing is assumed to be formed in a p-type well region. In the drawing, a photoelectric conversion unit 101 is illustrated as an example. The photoelectric conversion unit 101 includes an n-type semiconductor region 112. Specifically, a photodiode formed by pn junction between the n-type semiconductor region 112 and the p-type well region around the n-type semiconductor region 112 corresponds to the photoelectric conversion unit 101.

The wiring layer 122 is wiring that electrically connects the elements formed in the semiconductor substrate 111. The wiring layer 122 may include copper (Cu) and tungsten (W), for example. The insulating layer 121 insulates the wiring layer 122. The insulating layer 121 may include, for example, silicon oxide (SiO₂). The wiring region including the wiring layer 122 and the insulating layer 121 is formed on a front surface side of the semiconductor substrate 111.

The insulating film 130 is a film formed on a back surface side of the semiconductor substrate 111 to insulate the semiconductor substrate 111 and protect the semiconductor substrate 111. The insulating film 130 may include a metal oxide film such as aluminum oxide (Al₂O₃) and tantalum pentoxide (Ta₂O₅), an oxide such as SiO₂, and a nitride such as silicon nitride (SiN). Furthermore, the insulating film 130 may also include a film obtained by stacking these films. Note that the metal oxide film is a film that adjusts an interface state formed on the front surface of the semiconductor substrate 111. By arranging this metal oxide film, it is possible to reduce noise generated on the basis of emission of carriers from the interface state and the like. Furthermore, the insulating film 130 may also be used as an etching stopper when etching the incident light transmitting film 141 in order to form a groove for arranging the light-shielding body 142 to be described later in the incident light transmitting film 141.

The incident light transmitting film 141 is a film that is arranged adjacent to the insulating film 130 and transmits the incident light. The incident light transmitting film 141 may include an oxide such as SiO₂. Furthermore, the incident light transmitting film 141 may be formed by chemical vapor deposition (CVD) or atomic layer deposition (ALD). Note that the light-shielding body 142 to be described later is arranged in the groove formed in the incident light transmitting film 141.

The light-shielding body 142 is formed in the same layer as the incident light transmitting film 141 and is arranged on the peripheral edge of the pixel 100 and the like. The light-shielding body 142 may shield light obliquely incident from the adjacent pixel 100 and the like. As described later, the color filter 160 is arranged on the pixel 100 and the like, and the color filters 160 corresponding to different colors are arranged between the adjacent pixels 100. Therefore, when the light transmitted through the color filter 160 of the pixel 100 is incident on another pixel 100 adjacent thereto, color mixing and the like occurs in the another pixel 100 to generate noise. Therefore, by arranging the light-shielding body 142, it is possible to shield the incident light from the adjacent pixel 100 and prevent occurrence of the color mixing. The light-shielding body 142 may include, for example, metal such as aluminum (Al), tungsten (W), and copper (Cu), and a nitride such as tungsten nitride (N₂W). Furthermore, it is also possible to include resin in which a light-shielding material is dispersed.

Note that the light-shielding body 142 may be formed by embedding a material of the light-shielding body 142 in the groove formed in the incident light transmitting film 141.

The flattening film 151 is a film that flattens a surface on which the color filter 160 to be described later is formed. The flattening film 151 is formed so as to be stacked on the incident light transmitting film 141 in which the light-shielding body 142 is formed and a surface on which the light-shielding film 243 to be described later and the like is arranged and flattens these surfaces. Therefore, it is possible to prevent fluctuation in film thickness of the color filter 160. The flattening film 151 may include, for example, SiO₂ and SiN.

The color filter 160 is an optical filter that transmits light of a predetermined wavelength out of the incident light on the pixel 100 and the like. As the color filter 160, for example, the color filter 160 that transmits red light, green light, and blue light may be used.

The on-chip lens 171 is a lens that is arranged for each pixel 100 and the like and condenses the incident light in the photoelectric conversion unit 101. An upper layer of the on-chip lens 171 is formed into a hemispherical shape to form a lens. A lower layer of the on-chip lens 171 is arranged on a surface of the color filter 160 to flatten the surface of the color filter 160. Furthermore, the lower layer of the on-chip lens 171 protects a surface of the pixel array unit 10. The on-chip lens 171 may include, for example, resin.

As illustrated in the drawing, the pixel array unit 10 corresponds to a back-side illumination imaging element in which the incident light is applied from the back surface being a surface different from the front surface on which the wiring layer 122 is formed of the semiconductor substrate 111.

The light-shielding film 243 is arranged on the light-shielding pixel 200. The light-shielding film 243 is arranged adjacent to the incident light transmitting film 141 and the light-shielding body 142 and is arranged on the entire surface of the light-shielding pixels 200 in a plan view. Furthermore, the light-shielding film 243 is further arranged on the peripheral edge of the pixel array unit 10. It is possible to prevent occurrence of a step in the peripheral edge of the pixel array unit 10. Note that a contact 244 for connecting to the semiconductor substrate 111 is formed on the light-shielding film 243. The contact 244 is a film that prevents damage due to discharge when forming a light-shielding film 150. As described later, the light-shielding film 150 may be formed by depositing a material film such as metal by CVD and the like and etching the same. When plasma at the time of this CVD is incident on the material film and the material film is charged, there is a case where discharge occurs between the same and the semiconductor substrate 111 and the like, resulting in damage. Therefore, by forming the contact 244, it is possible to prevent the material film from being charged. The contact 244 may be formed by arranging the light-shielding film 150 in an opening formed through the incident light transmitting film 141 and the insulating film 130.

The light-shielding films 343a and 343b are arranged on the phase difference pixels 301 and 302, respectively. The light-shielding films 343a and 343b may also be arranged adjacent to the incident light transmitting film 141 and the light-shielding body 142 as is the case with the light-shielding film 243. As described above, the light-shielding films 343a and 343b shield light in a region half the opening of the light-shielding body 142 in the phase difference pixels 301 and 302, respectively.

The light-shielding films 243, 343a, and 343b may be simultaneously formed. In contrast, the light-shielding films 243, 343a, and 343b are formed at a step different from that of the light-shielding body 142 as described later.

Note that the configuration of the pixel array unit 10 is not limited to this example. For example, it is possible to form a bottom of the light-shielding body 142 into a shape not coming into contact with the insulating film 130. For example, it is possible to form a groove of a depth to the middle of the incident light transmitting film 141 by adjusting the depth of the groove of the incident light transmitting film 141 in which the light-shielding body 142 is arranged and arrange the light-shielding body 142. Furthermore, it is also possible to form the incident light transmitting film 141 by using a plurality of films, and form the groove in an upper film out of the plurality of films.

### [Manufacturing Method of Imaging Element]

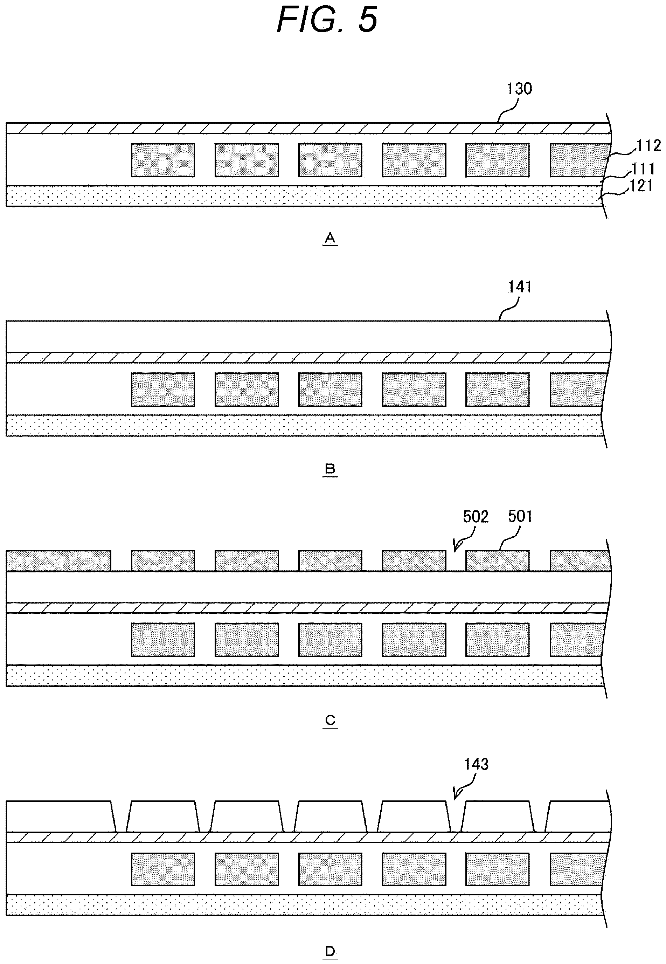

Figs. 5 to 8 are views illustrating an example of a manufacturing method of the pixel array unit according to the first embodiment of the present disclosure. First, the well region and the n-type semiconductor region 112 are formed in the semiconductor substrate 111. By this, the photoelectric conversion unit 101 may be formed. This step is an example of a step of forming a photoelectric conversion unit in a semiconductor substrate recited in claims. Next, the insulating layer 121 and the wiring layer 122 (not illustrated) are formed. Next, the semiconductor substrate 111 is inverted upside down, and the back surface side thereof is ground to thin the semiconductor substrate 111. Next, the insulating film 130 is formed on the back surface of the semiconductor substrate 111 (A in Fig. 5). This may be performed, for example, by sputtering.

Next, the incident light transmitting film 141 is arranged on a surface of the insulating film 130. This may be performed, for example, by CVD to which high density plasma (HDP) is applied (B in Fig. 5).

Next, a resist 501 is formed on a surface of the incident light transmitting film 141. An opening 502 is formed in the resist 501 in a position in which the light-shielding body 142 is arranged (C in Fig. 5). Next, using the resist 501 as a mask, the incident light transmitting film 141 is etched to form a groove 143. For example, dry etching may be applied to this etching. The etching needs to be stopped at an interface with the insulating film 130. This may be performed by adjusting etching rate and time. Note that it is possible to preferably simplify an etching step by adopting a film that stops progress of the etching as the insulating film 130 (D in Fig. 5). This step is an example of a step of forming a groove in an incident light transmitting film recited in claims.

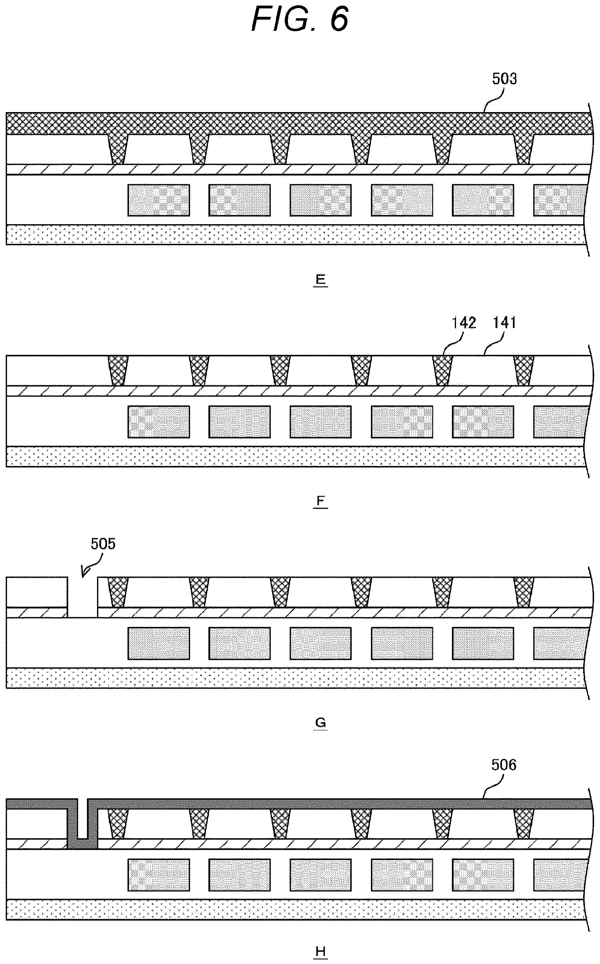

Next, a material film 503 of the light-shielding body 142 is stacked on the surface of the incident light transmitting film 141, and the material film 503 of the light-shielding body 142 is embedded to be arranged in the groove 143. This may be performed, for example, by CVD (E in Fig. 6). Next, a surface of the material film 503 of the light-shielding body 142 is ground to remove the material film 503 of the light-shielding body 142 arranged outside the groove 143. This may be performed, for example, by chemical mechanical polishing (CMP). Therefore, the light-shielding body 142 may be formed (F in Fig. 6). The step is an example of a step of arranging a light-shielding body recited in claims.

Next, an opening 505 is formed in the incident light transmitting film 141 and the insulating film 130. This may be performed by dry etching (G in Fig. 6).

Next, a material film 506 of the light-shielding film 243 and the like is stacked on the surfaces of the incident light transmitting film 141 and the light-shielding body 142. At that time, the material film 506 is also arranged in the opening 505. This may be performed, for example, by CVD (H in Fig. 6).

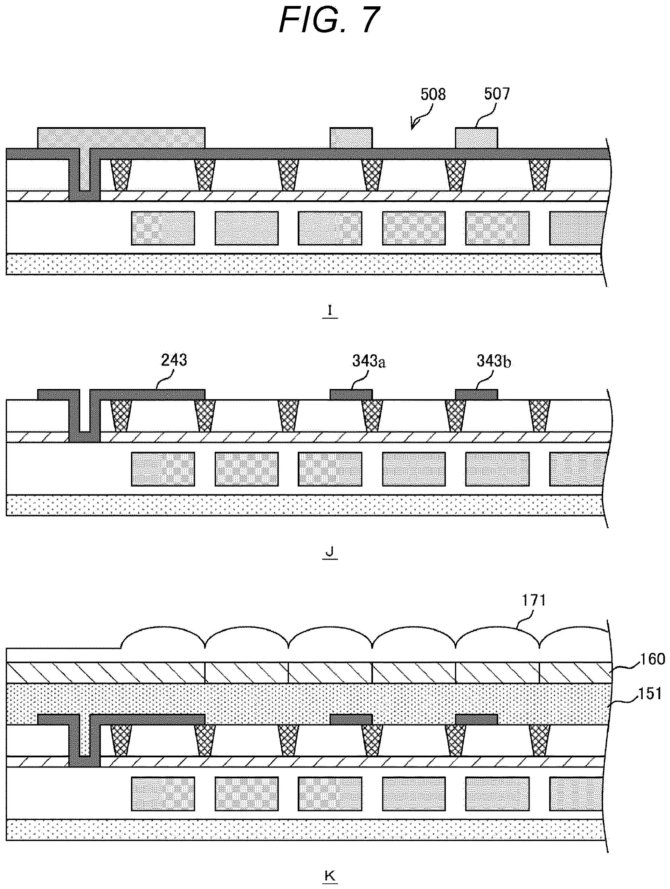

Next, a resist 507 is arranged on a surface of the material film 506. In this resist 507, an opening 508 is formed in a region in which the light-shielding film 243 is not arranged such as the surface of the pixel 100 and the like (I in Fig. 7).

Next, the material film 506 is etched using the resist 507 as a mask. This may be performed, for example, by dry etching. Therefore, the light-shielding films 243, 343a, and 343b may be formed (J in Fig. 7) .

Next, the flattening film 151 and the color filter 160 are sequentially stacked in this order. Next, the resin serving as the material of the on-chip lens 171 is applied and then processed into a hemispherical shape to form the on-chip lens 171 (K in Fig. 7). At the above-described steps, the pixel array unit 10 may be manufactured.

### [Configuration of Conventional Pixel]

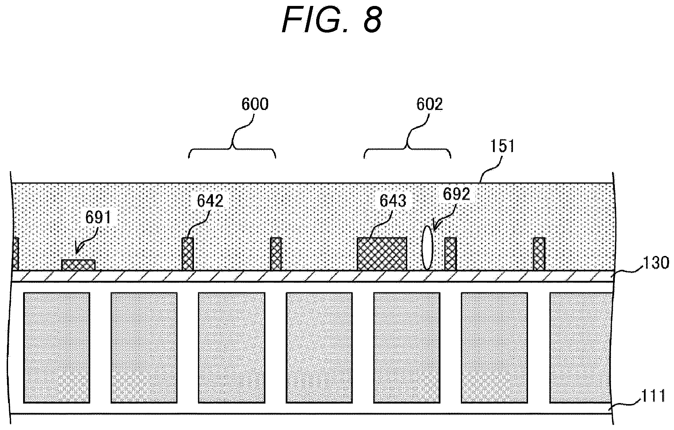

Fig. 8 is a view illustrating a configuration example of a pixel according to a conventional imaging element. The drawing is a simplified view of a conventional pixel as a comparative example. The imaging element in the drawing is provided with a pixel 600 and a phase difference pixel 602. On the pixel 600, a light-shielding film 642 is arranged in place of the incident light transmitting film 141 and the light-shielding body 142. Furthermore, a light-shielding film 643 is arranged on the phase difference pixel 602. Note that a similar light-shielding film is also arranged on a light-shielding pixel not illustrated. The light-shielding films 642 and 643 are formed by etching a material film arranged adjacent to an insulating film 130 formed on a semiconductor substrate 111. That is, in the conventional imaging element, the light-shielding film arranged on a peripheral edge of the pixel and the light-shielding film for pupil-split in the phase difference pixel are simultaneously formed. Thereafter, a flattening film 151 is arranged so as to cover the light-shielding films 642 and 643. A step may be shortened by simultaneously forming the light-shielding film arranged on the peripheral edge of the pixel and the light-shielding film for pupil-split in the phase difference pixel.

However, in the imaging element in the drawing, when a size of the pixel 600 becomes smaller as the imaging element is made finer, it becomes difficult to form the light-shielding film due to occurrence of defects. Specifically, as in a light-shielding film 691 in the drawing, the defect due to falling of the light-shielding film 642 is likely to occur. Furthermore, since a distance between the light-shielding films 642 and 643 becomes narrow, a material of the flattening film 151 cannot penetrate, and there is a case where a clearance 692 is formed in the flattening film 151. When such clearance 692 is formed, an error in phase difference detection in the phase difference pixel 602 increases.

In contrast, in the imaging element (pixel array unit 10) in Fig. 4, as described with reference to Figs. 6 to 7, the material film 503 of the light-shielding body 142 is embedded in the groove formed in the incident light transmitting film 141 to form the light-shielding body 142. The light-shielding body 142 is formed by a method according to a damascene method used at a step of manufacturing Cu wiring of a semiconductor element. Fine processing of the light-shielding body 142 may be easily performed, and the light-shielding body 142 may be formed without causing the defect such as the falling described above. Furthermore, since the light-shielding body 142 and the light-shielding films 343a and 343b are formed at different steps, the formation of the clearance described above and the like may be prevented.

Furthermore, since the light-shielding body 142 in Fig. 4 is arranged in the groove formed in the incident light transmitting film 141, this may be formed into a tapered shape. That is, a portion closer to the photoelectric conversion unit 101 is formed to have a narrower width. The opening in a region closer to the photoelectric conversion unit 101 may be widened, and deterioration in sensitivity may be prevented.

Furthermore, as described with reference to Fig. 7, the light-shielding films 243, 343a, and 343b in Fig. 4 are formed at the etching step using the resist 507 as the mask. Since they may be formed without using CMP, it is possible to prevent formation of a recess due to dishing.

As described above, since the light-shielding body 142 is arranged in the groove formed in the incident light transmitting film 141 in the pixel array unit 10 of the first embodiment of the present disclosure, the light-shielding body 142 may be formed even in a case where the pixel 100 and the like is made finer.

### <2. Second Embodiment>

In the pixel array unit 10 of the first embodiment described above, the light-shielding films 343a and 343b are arranged on the phase difference pixels 301 and 302, respectively. In contrast, a pixel array unit 10 of a second embodiment of the present disclosure is different from the first embodiment described above in further including a light-shielding body arranged on an end of light-shielding films 343a and 343b.

### [Configuration of Pixel]

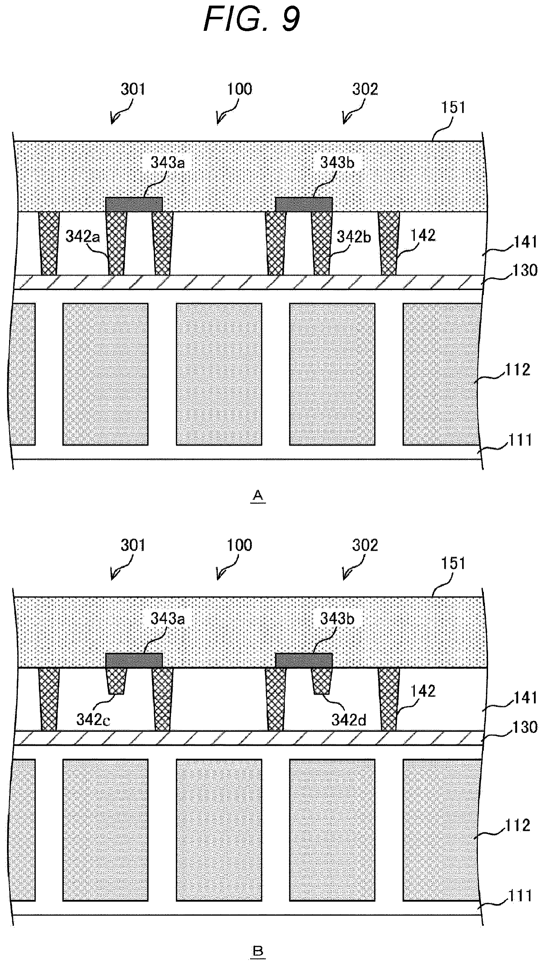

Fig. 9 is a view illustrating a configuration example of a pixel according to the second embodiment of the present disclosure. The drawing is a simplified view of a configuration of a pixel 100 and phase difference pixels 301 and 302. The phase difference pixels 301 and 302 in A of the drawing are provided with light-shielding bodies 342a and 342b, respectively. The light-shielding bodies 342a and 342b are arranged in the vicinity of light-shielding films 343a and 343b, respectively, and are arranged in grooves formed in an incident light transmitting film 141. By arranging the light-shielding bodies 342a and 342b, it is possible to prevent diffraction of incident light by the light-shielding films 343a and 343b, and it is possible to reduce generation of noise due to diffracted light. Bottoms of the light-shielding bodies 342a and 342b in the drawing reach an interface with an insulating film 130, and a noise reduction effect may be improved. Note that, as illustrated in the drawing, the light-shielding bodies 342a and 342b are preferably formed in positions in which ends thereof coincide with ends of the light-shielding films 343a and 343b, respectively. This is because the diffracted light may be shielded without affecting pupil-split by the light-shielding films 343a and 343b.

The phase difference pixels 301 and 302 in B of the drawing are provided with light-shielding bodies 342c and 342d in place of the light-shielding bodies 342a and 342b, respectively. The light-shielding bodies 342c and 342d are formed to reach a shallower depth than the light-shielding bodies 342a and 342b, respectively. Therefore, it is possible to reduce deterioration in sensitivity as compared with a case where the light-shielding bodies 342a and 342b are arranged. Grooves in which the light-shielding bodies 342c and 342d are arranged may be formed at a step different from that of a groove in which a light-shielding body 142 is arranged. The light-shielding bodies 342c and 342d may be arranged by forming the grooves of desired depths by adjusting etching time.

Note that the light-shielding bodies 342a, 342b, 342c, and 342d are an example of a second light-shielding body recited in claims.

Since a configuration of an imaging device 1 other than this is similar to the configuration of the imaging device 1 described in the first embodiment of the present disclosure, the description thereof is omitted.

As described above, in the pixel array unit 10 of the second embodiment of the present disclosure, the light-shielding bodies 342a and 342b and the like are arranged in the vicinity of the light-shielding films 343a and 343b of the phase difference pixels 301 and 302, respectively. Therefore, it is possible to reduce generation of noise in the phase difference pixels 301 and 302.

### <3. Third Embodiment>

Conventionally, an imaging device provided with a pixel array unit including a light-shielding wall of a plurality of stages between pixels is used in an imaging element. The light-shielding wall is formed in the same layer as a flattening film arranged between an insulating film on a semiconductor substrate surface and a color filter in the pixel and is arranged at a boundary with an adjacent pixel. Light from a subject of a high image height is obliquely incident on the pixel on a peripheral edge of the imaging element. When the incident light is obliquely incident between adjacent pixels, color mixing and the like occurs. Therefore, by arranging the light-shielding wall, the oblique incident light from the adjacent pixel is shielded (refer to, for example, Patent Document 1). In a case where a phase difference pixel is arranged, a height of the imaging element increases in order to adjust a light condensing position in the pixel. In this case, a multistage light-shielding wall is arranged.

The above-described conventional technology has a problem that an image quality is deteriorated due to the incident light at a high incident angle incident on the pixel. When the light from the subject is reflected by a housing and the like to reach the imaging element, there is a case where this is incident on the pixel at an extremely high incident angle. In this case, such incident light causes noise in an image signal, resulting in deterioration in image quality.

In the third embodiment of the present disclosure, in view of the above-described problems, an imaging element that eases deterioration in image quality even in a case where incident light at a high incident angle is incident is proposed.

### [Configuration of Pixel]

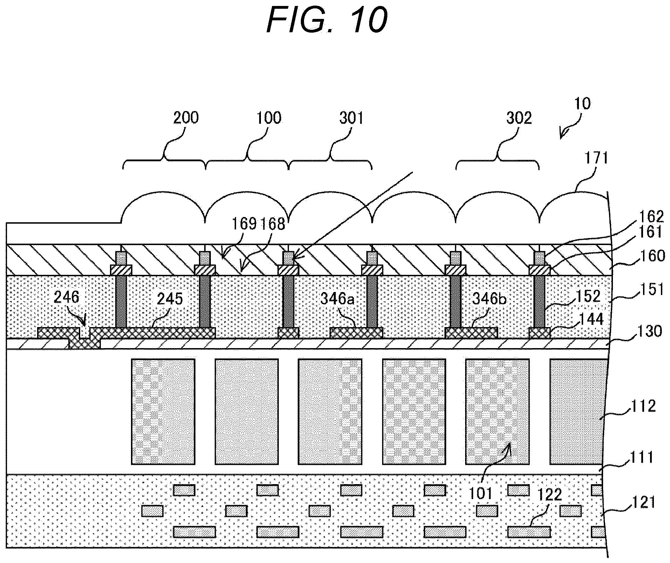

Fig. 10 is a view illustrating a configuration example of a pixel according to the third embodiment of the present disclosure. The drawing is a schematic cross-sectional view illustrating a configuration example of the pixel 100, the light-shielding pixel 200, and the phase difference pixels 301 and 302 arranged in the pixel array unit 10. The pixel array unit 10 in the drawing is different from the pixel array unit 10 described with reference to Fig. 4 in the following points. The incident light transmitting film 141 is omitted, and a light-shielding film 144 is arranged on the pixel 100 in place of the light-shielding body 142. A light-shielding film 245 is arranged on the light-shielding pixel 200 in place of the light-shielding film 243. Light-shielding films 346a and 346b are arranged on the phase difference pixels 301 and 302, respectively. Furthermore, a light-shielding wall 152 is further arranged. Furthermore, a first color filter unit light-shielding layer 162 and a second color filter unit light-shielding layer 161 are further arranged.

The light-shielding film 144 is a light-shielding film that is arranged adjacent to the insulating film 130 and is arranged on a peripheral edge of the pixel 100. Furthermore, the light-shielding film 245 is arranged adjacent to the insulating film 130 and is arranged on an entire surface of the light-shielding pixels 200 in a plan view. Furthermore, a contact 246 is formed on the light-shielding film 245. Furthermore, the light-shielding films 346a and 346b are light-shielding films arranged on the phase difference pixels 301 and 302 for pupil-splitting the phase difference pixels 301 and 302, respectively. The light-shielding films 144, 245, 346a, and 346b may be simultaneously formed.

The light-shielding wall 152 is arranged in a wall shape around a flattening film 151 of each pixel 100 and the like to shield the incident light. That is, the light-shielding wall 152 is arranged in the vicinity of a boundary of the pixel 100. The light-shielding wall 152 may be formed so as to be stacked on the light-shielding film 144. The light-shielding wall 152 may include, for example, W, Al and the like.

The second color filter unit light-shielding layer 161 is arranged in the same layer as a color filter 160 to shield the incident light. An opening 168 is formed in the central portion of the second color filter unit light-shielding layer 161. The color filter 160 is arranged in this opening 168. That is, the second color filter unit light-shielding layer 161 is arranged in the vicinity of the boundary of the pixel 100. Furthermore, the second color filter unit light-shielding layer 161 is arranged between the first color filter unit light-shielding layer 162 to be described later and a semiconductor substrate 111.

The first color filter unit light-shielding layer 162 is arranged in the same layer as the color filter 160 to shield the incident light. An opening 169 is formed in the central portion of the first color filter unit light-shielding layer 162 as is the case with the second color filter unit light-shielding layer 161. The color filter 160 is arranged in this opening 169. That is, as is the case with the second color filter unit light-shielding layer 161, the first color filter unit light-shielding layer 162 is also arranged in the vicinity of the boundary of the pixel 100.

The first color filter unit light-shielding layer 162 and the second color filter unit light-shielding layer 161 shield the light obliquely incident from the adjacent pixels 100 and the like at a high incident angle. An arrow in the drawing indicates a state in which the incident light at a high incident angle is shielded by the first color filter unit light-shielding layer 162. In this manner, by arranging the first color filter unit light-shielding layer 162 and the second color filter unit light-shielding layer 161 in the same layer as the color filter 160, it is possible to prevent the occurrence of the color mixing due to the incident light at a high incident angle.

The first color filter unit light-shielding layer 162 and the second color filter unit light-shielding layer 161 may include different materials. For example, the first color filter unit light-shielding layer 162 may include resin in which a carbon black pigment, a titanium black pigment and the like is dispersed, and the second color filter unit light-shielding layer 161 may include a metal material such as W and Al. Since the first color filter unit light-shielding layer 162 including the resin is arranged on an outermost portion of the color filter unit light-shielding layer and the light-shielding wall, it is possible to reduce reflection of the incident light of the pixel array unit 10. Furthermore, the first color filter unit light-shielding layer 162 including the resin preferably has transmissivity of 30% with respect to light of a wavelength of 300 to 1000 nm. This is because a light-shielding ability of the incident light may be improved. Furthermore, the first color filter unit light-shielding layer 162 may be formed to have a thickness of 100 to 1000 nm. Note that a photoresist is preferably adopted as the resin forming the first color filter unit light-shielding layer 162. This is because a manufacturing step of the first color filter unit light-shielding layer 162 may be simplified.

Furthermore, by stacking the first color filter unit light-shielding layer 162 and the second color filter unit light-shielding layer 161, a thickness of the light-shielding layer arranged in a region of the color filter 160 may be increased, and the light-shielding ability may be improved. The color filter 160 is formed to have a relatively thick film thickness in order to obtain a desired optical characteristic. Therefore, it is necessary to form the color filter unit light-shielding layer arranged in the same layer as the color filter 160 to have a thick film thickness. However, in a case where the color filter unit light-shielding layer includes resin, if the color filter unit light-shielding layer is made thick, reading failure of an alignment mark arranged in a lower layer occurs at the manufacturing step. Exposure position accuracy in a photography process is deteriorated, making it difficult to manufacture the imaging element. In contrast, in a case where the color filter unit light-shielding layer includes metal, if the color filter unit light-shielding layer is made thick, warpage of the semiconductor substrate 111 when depositing the metal film increases. It becomes difficult to manufacture as is the case of forming by using resin.

Therefore, each of the first color filter unit light-shielding layer 162 and the second color filter unit light-shielding layer 161 includes resin and metal, and they are stacked to be arranged. Therefore, the color filter unit light-shielding layer having a desired film thickness may be easily manufactured.

Furthermore, as illustrated in the drawing, a size (width) of the second color filter unit light-shielding layer 161 is preferably made larger than a size (width) of the first color filter unit light-shielding layer 162. That is, the opening 168 of the second color filter unit light-shielding layer 161 is made narrower than the opening 169 of the first color filter unit light-shielding layer 162. Therefore, a margin of misalignment at the time of manufacturing may be improved.

Similarly, as illustrated in the drawing, the size (width) of the second color filter unit light-shielding layer 161 is preferably made larger than a size (width) of the light-shielding wall 152. Similarly, this is for improving the margin of misalignment at the time of manufacturing.

A manufacturing method of the imaging element (pixel array unit 10) is described in detail in a fourth embodiment.

Since a configuration of an imaging device 1 other than this is similar to the configuration of the imaging device 1 described in the first embodiment of the present disclosure, the description thereof is omitted.

As described above, in the pixel array unit 10 of the third embodiment of the present disclosure, the first color filter unit light-shielding layer 162 and the second color filter unit light-shielding layer 161 are arranged in the same layer as the color filter 160. Therefore, it is possible to shield the light obliquely incident from the adjacent pixel 100 and the like at a high incident angle, and prevent deterioration in image quality.

### <4. Fourth Embodiment>

In the pixel array unit 10 of the third embodiment described above, the first color filter unit light-shielding layer 162 and the second color filter unit light-shielding layer 161 are arranged adjacent to each other, and the second color filter unit light-shielding layer 161 and the light-shielding wall 152 are arranged adjacent to each other. In contrast, a pixel array unit 10 of a fourth embodiment of the present disclosure is different from that of the third embodiment described above in including an interlayer film between a first color filter unit light-shielding layer 162, a second color filter unit light-shielding layer 161, and a light-shielding wall 152.

### [Configuration of Pixel]

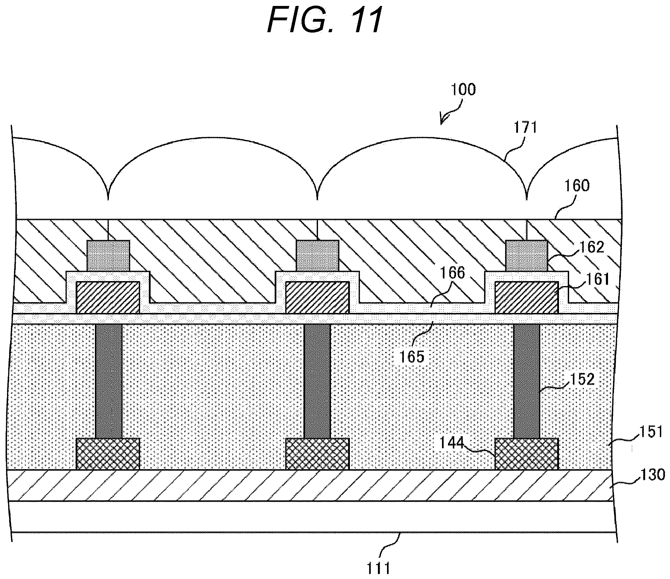

Fig. 11 is a view illustrating a configuration example of a pixel according to the fourth embodiment of the present disclosure. The drawing is a simplified view of a configuration of a pixel 100. The pixel 100 in the drawing is different from the pixel 100 described with reference to Fig. 10 in further including interlayer films 165 and 166.

The interlayer film 165 is an interlayer film arranged between the light-shielding wall 152 and the second color filter unit light-shielding layer 161. The interlayer film 165 may include, for example, an inorganic material such as SiO₂ and SiN. By arranging the interlayer film 165, it is possible to protect the light-shielding wall 152 arranged in a lower layer when forming the second color filter unit light-shielding layer 161. Specifically, when a metal film serving as a material of the second color filter unit light-shielding layer 161 is formed on a flattening film 151 on which the light-shielding wall 152 is arranged and etched, there is a case where a chemical solution used at an etching step infiltrates and the light-shielding wall 152 elutes. Therefore, by arranging the interlayer film 165 to separate, the light-shielding wall 152 may be protected from the chemical solution at the etching step.

The interlayer film 166 is an interlayer film arranged between the first color filter unit light-shielding layer 162 and the second color filter unit light-shielding layer 161. As is the case with the interlayer film 165, the interlayer film 166 may also include an inorganic material. In a case where the first color filter unit light-shielding layer 162 including resin is arranged adjacent to the second color filter unit light-shielding layer 161 including metal, adhesion strength between them is relatively low, so that a problem such as peeling might occur. Therefore, the interlayer film 166 including the inorganic material is arranged between them. Therefore, the adhesion strength may be improved.

Note that the configuration of the pixel array unit 10 is not limited to this example. For example, this may be provided with any one of the interlayer films 165 and 166.

Note that the interlayer film 166 is an example of an interlayer film recited in claims. The interlayer film 165 is an example of a second interlayer film recited in claims.

### [Manufacturing Method of Imaging Element]

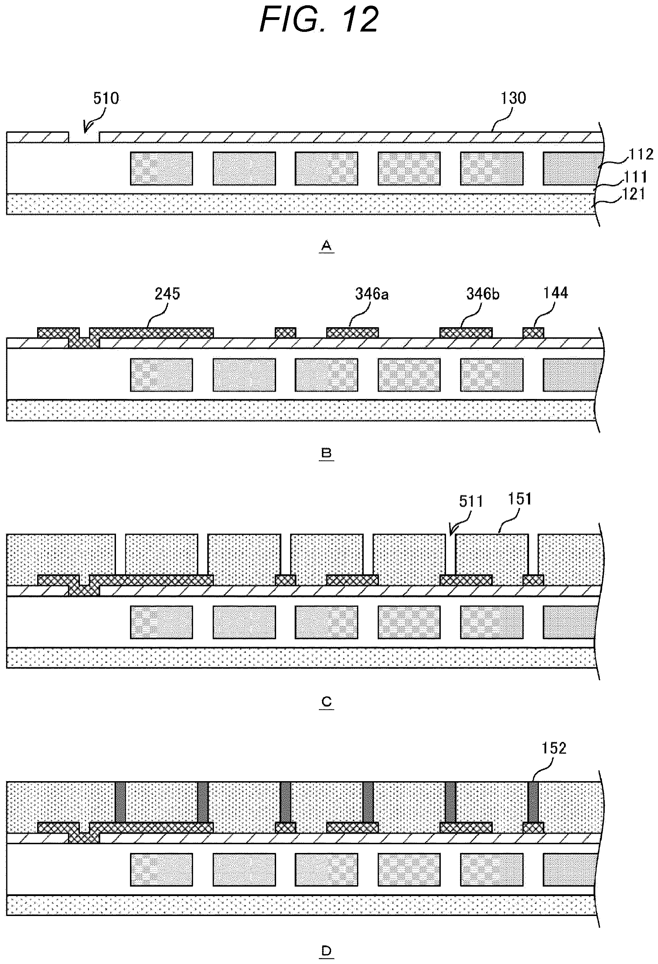

Figs. 12 to 15 are views illustrating an example of a manufacturing method of the pixel array unit according to the fourth embodiment of the present disclosure. First, a well region and an n-type semiconductor region 112 are formed in a semiconductor substrate 111 to form a photoelectric conversion unit 101. Next, the insulating layer 121 and the wiring layer 122 (not illustrated) are formed. Next, an insulating film 130 including an opening 510 is formed on a back surface of the semiconductor substrate 111 (A in Fig. 12).

Next, a metal film serving as a material of a light-shielding film 245 and the like is deposited and etched to form light-shielding films 144, 245, 346a, and 346b (B in Fig. 12).

Next, the flattening film 151 is arranged adjacent to the light-shielding film 144 and the like, and an opening 511 is formed in a portion in which the light-shielding wall 152 is arranged (C in Fig. 12) .

Next, a metal film serving as a material of the light-shielding wall 152 is stacked on the flattening film 151, and a surface of the stacked metal film is ground. This may be performed, for example, by CMP. Therefore, the light-shielding wall 152 may be arranged in the opening 511 of the flattening film 151 (D in Fig. 12).

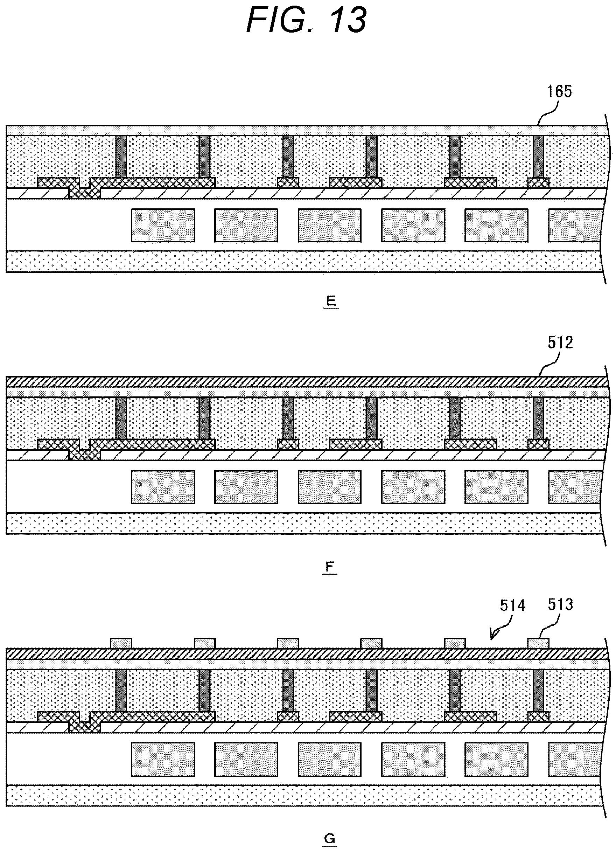

Next, the interlayer film 165 is arranged adjacent to the flattening film 151 and the light-shielding wall 152 (E in Fig. 13).

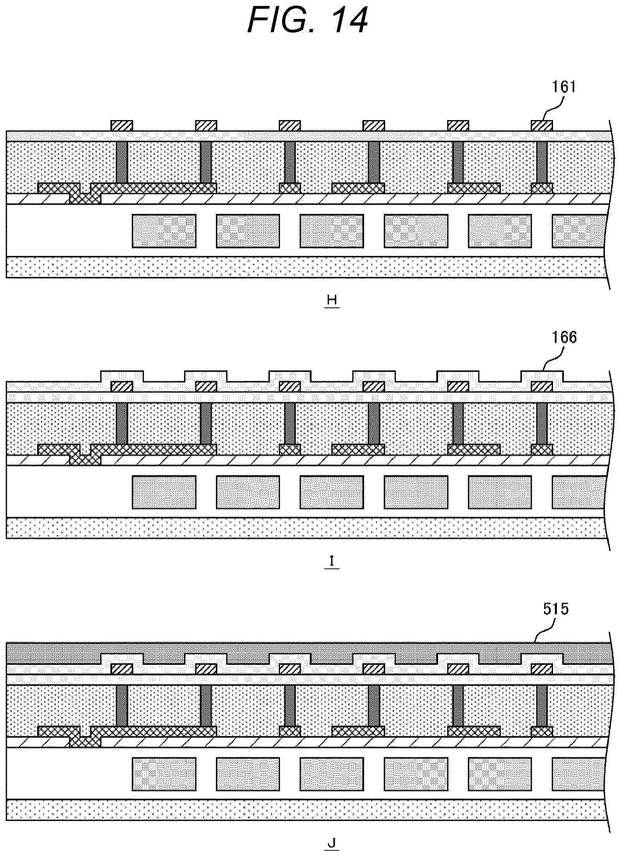

Next, a metal film 512 serving as a material of the second color filter unit light-shielding layer 161 is stacked (F in Fig. 13). Next, a resist 513 is arranged on a surface of the metal film 512. The resist 513 is provided with an opening 514 in a region in which the opening 168 described with reference to Fig. 10 is arranged (G in Fig. 13). Next, the metal film 512 is etched using the resist 513 as a mask to form the second color filter unit light-shielding layer 161 including the opening 168 (H in Fig. 14). This step is an example of a step of arranging a second color filter unit light-shielding layer on a semiconductor substrate recited in claims.

Next, the interlayer film 166 is arranged adjacent to the second color filter unit light-shielding layer 161 and the interlayer film 165 (I in Fig. 14).

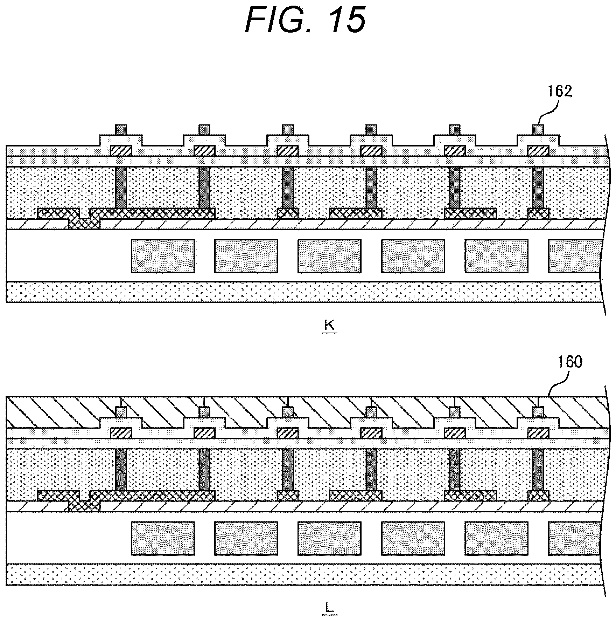

Next, a resin film 515 serving as a material of the first color filter unit light-shielding layer 162 is arranged adjacent to the interlayer film 166 (J in Fig. 14). Next, the first color filter unit light-shielding layer 162 is formed from the resin film 515 by a photography technology. Specifically, the resin film 515 is exposed and developed to form an opening 169, and this is processed into a shape of the first color filter unit light-shielding layer 162 (K in Fig. 15). This step is an example of a step of stacking a first color filter unit light-shielding layer on a second color filter unit light-shielding layer to arrange recited in claims.

Next, the color filter 160 is arranged adjacent to the interlayer film 166 and the first color filter unit light-shielding layer 162 (L in Fig. 15). The step is an example of a step of arranging a color filter recited in claims. Note that although the interlayer film 166 in the drawing is illustrated to have the same film thickness as that of the second color filter unit light-shielding layer 161 for convenience, the color filter 160 is arranged in the opening 168 of the second color filter unit light-shielding layer 161 and the opening 169 of the first color filter unit light-shielding layer 162. Next, by arranging an on-chip lens 171, the pixel array unit 10 may be manufactured.

Since a configuration of an imaging device 1 other than this is similar to the configuration of the imaging device 1 described in the third embodiment of the present disclosure, the description thereof is omitted.

As described above, in the pixel array unit 10 of the fourth embodiment of the present disclosure, the light-shielding wall 152 may be protected by arranging the interlayer film 165. Furthermore, by arranging the interlayer film 166, the adhesion strength of the first color filter unit light-shielding layer 162 may be improved.

### <5. Fifth Embodiment>

The pixel array unit 10 of the third embodiment described above is provided with the on-chip lens 171. In contrast, a pixel array unit 10 of a fifth embodiment of the present disclosure is different from that in the third embodiment described above in further including an interlayer lens 172.

### [Configuration of Pixel]

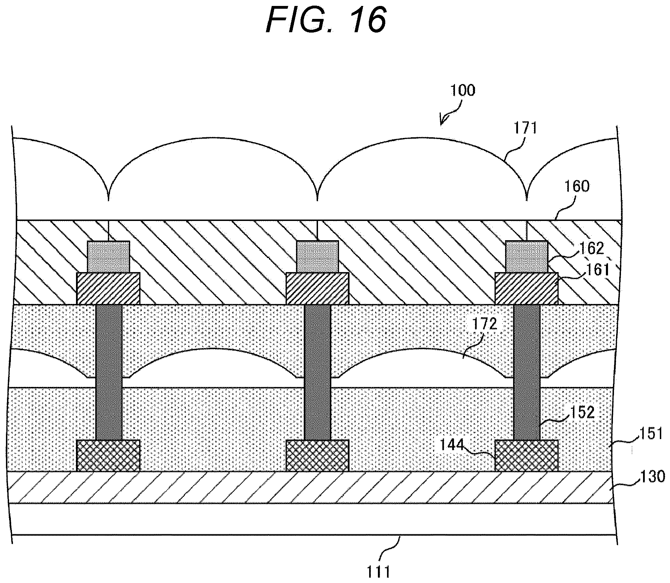

Fig. 16 is a view illustrating a configuration example of a pixel according to the fifth embodiment of the present disclosure. The drawing is a simplified view of a configuration of a pixel 100. The pixel 100 in the drawing is different from the pixel 100 described with reference to Fig. 10 in further including the interlayer lens 172.

The interlayer lens 172 is a lens arranged on a flattening film 151 to further condense incident light condensed by an on-chip lens 171. By arranging the interlayer lens 172, sensitivity of the pixel 100 may be improved. Light from a subject is obliquely incident on the pixel 100 arranged on a peripheral edge of the pixel array unit 10. In such a case, the on-chip lens 171 alone cannot condense the incident light on a photoelectric conversion unit 101, and the sensitivity is deteriorated. Therefore, by arranging the interlayer lens 172, the incident light is further refracted to be condensed on the photoelectric conversion unit 101. Therefore, the deterioration in sensitivity may be reduced. The interlayer lens 172 may include, for example, SiN and silicon oxynitride (SiON). Furthermore, the interlayer lens 172 may be formed by a method similar to that of the on-chip lens 171.

Since a configuration of an imaging device 1 other than this is similar to the configuration of the imaging device 1 described in the third embodiment of the present disclosure, the description thereof is omitted.

As described above, the pixel array unit 10 of the fifth embodiment of the present disclosure may reduce the deterioration in sensitivity by arranging the interlayer lens 172.

### <6. Sixth Embodiment>

The pixel array unit 10 of the third embodiment described above is provided with the first color filter unit light-shielding layer 162 and the second color filter unit light-shielding layer 161 formed to have rectangular cross-sections. In contrast, a pixel array unit 10 of a sixth embodiment of the present disclosure is different from that of the third embodiment described above in including a first color filter unit light-shielding layer and a second color filter unit light-shielding layer formed to have tapered cross-sections.

### [Configuration of Pixel]

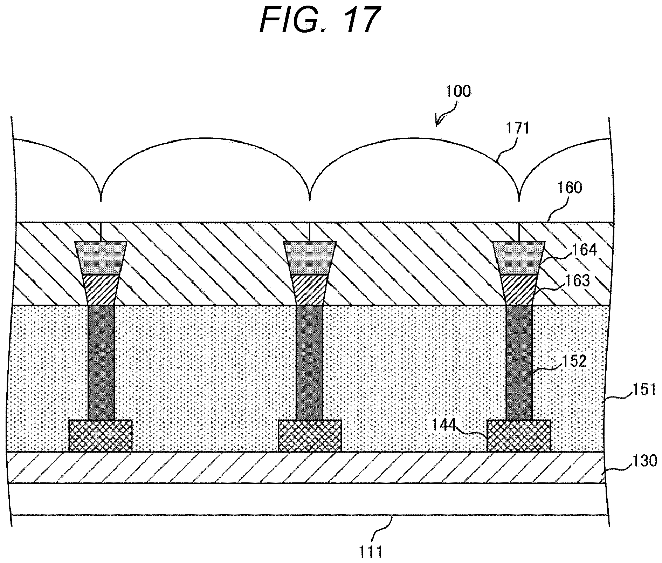

Fig. 17 is a view illustrating a configuration example of a pixel according to the sixth embodiment of the present disclosure. The drawing is a simplified view of a configuration of a pixel 100. The pixel 100 in the drawing is different from the pixel 100 described with reference to Fig. 10 in including a first color filter unit light-shielding layer 164 and a second color filter unit light-shielding layer 163 in place of the first color filter unit light-shielding layer 162 and the second color filter unit light-shielding layer 161, respectively.

As illustrated in the drawing, the first color filter unit light-shielding layer 164 and the second color filter unit light-shielding layer 163 are formed to have tapered cross-sections. Specifically, they are formed to have cross-sectional shapes in which a width becomes narrower toward a semiconductor substrate 111 of the pixel 100. Therefore, an opening on a lower side of the first color filter unit light-shielding layer 164 and the second color filter unit light-shielding layer 163 is widened, and it is possible to prevent deterioration in sensitivity. Note that, the configuration of the pixel 100 is not limited to this example. For example, it is possible to adopt a configuration in which any one of the first color filter unit light-shielding layer 164 and the second color filter unit light-shielding layer 163 formed to have the tapered shapes is arranged.

Since a configuration of an imaging device 1 other than this is similar to the configuration of the imaging device 1 described in the third embodiment of the present disclosure, the description thereof is omitted.

As described above, in the pixel array unit 10 of the sixth embodiment of the present disclosure, the deterioration in sensitivity may be reduced by arranging the first color filter unit light-shielding layer 164 and the second color filter unit light-shielding layer 163 formed to have the tapered cross-sections.

### <7. Seventh Embodiment>

In the pixel array unit 10 of the third embodiment described above, the color filter 160 is formed into the shape covering the first color filter unit light-shielding layer 162. In contrast, a pixel array unit 10 of a seventh embodiment of the present disclosure is different from that of the third embodiment described above in that a color filter 160 is formed into a shape separated by a first color filter unit light-shielding layer.

### [Configuration of Pixel]

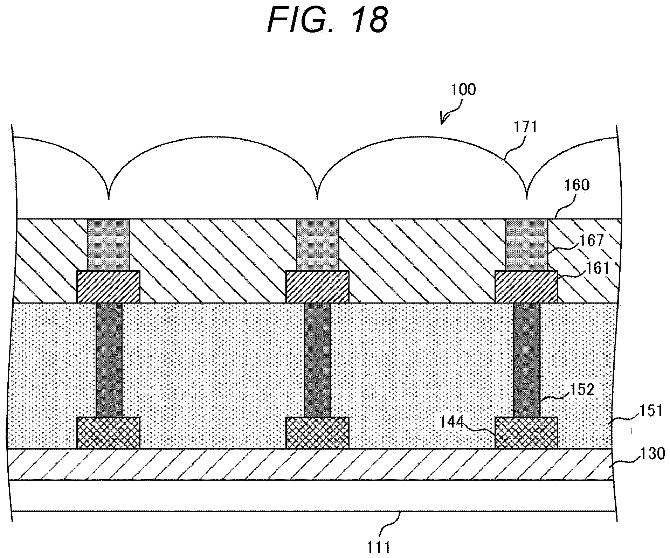

Fig. 18 is a view illustrating a configuration example of a pixel according to the seventh embodiment of the present disclosure. The drawing is a simplified view of a configuration of a pixel 100. The pixel 100 in the drawing is different from the pixel 100 described with reference to Fig. 10 in including a first color filter unit light-shielding layer 167 in place of the first color filter unit light-shielding layer 162.

As illustrated in the drawing, the first color filter unit light-shielding layer 167 is formed into a shape in which an apex thereof is adjacent to an on-chip lens 171. Therefore, the color filter 160 is arranged only in an opening of the first color filter unit light-shielding layer 167 and a second color filter unit light-shielding layer 161 and is separated by the first color filter unit light-shielding layer 167 and the like. Therefore, it is possible to shield light obliquely incident from adjacent pixel 100 in the vicinity of a surface of the color filter 160.

Since a configuration of an imaging device 1 other than this is similar to the configuration of the imaging device 1 described in the third embodiment of the present disclosure, the description thereof is omitted.

As described above, the pixel array unit 10 of the seventh embodiment of the present disclosure is formed into the shape such that the color filter 160 is separated by the first color filter unit light-shielding layer 167. Therefore, it is possible to shield the oblique incident light in the vicinity of the surface of the color filter 160, and further reduce deterioration in image quality.

### <8. Eighth Embodiment>

In the pixel array unit 10 of the third embodiment described above, the light-shielding film 245 is arranged on the peripheral edge of the pixel array unit 10. In contrast, a pixel array unit 10 of an eighth embodiment of the present disclosure is different from that of the third embodiment described above in that a first color filter unit light-shielding layer is further arranged on a peripheral edge of the pixel array unit 10.

### [Configuration of Pixel]

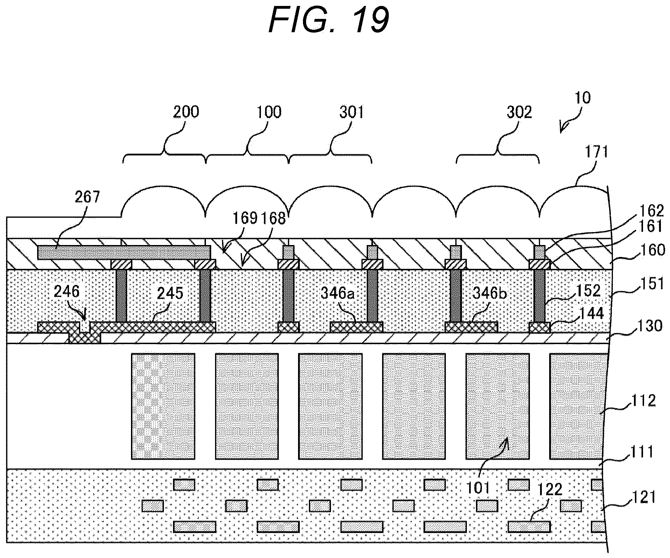

Fig. 19 is a view illustrating a configuration example of a pixel according to the eighth embodiment of the present disclosure. A light-shielding pixel 200 in the drawing is different from the pixel 100 described with reference to Fig. 10 in including a first color filter unit light-shielding layer 267.

Similar to the light-shielding film 245, the first color filter unit light-shielding layer 267 shields an entire surface of the light-shielding pixel 200 and is arranged on the peripheral edge of the pixel array unit 10. By forming the first color filter unit light-shielding layer 267 by using resin, it is possible to reduce reflection of incident light in this region. When reflected light is incident on the pixel array unit 10 again and is photoelectrically converted by the pixel 100, this causes noise. Since this reflected light may be reduced, deterioration in image quality may be prevented.

Note that a configuration of an imaging device 1 is not limited to this example. For example, it is possible to arrange a color filter unit light-shielding layer including metal as is the case with the second color filter unit light-shielding layer 161 in the light-shielding pixel 200 and the like

Since a configuration of an imaging device 1 other than this is similar to the configuration of the imaging device 1 described in the third embodiment of the present disclosure, the description thereof is omitted.

As described above, in the pixel array unit 10 of the eighth embodiment of the present disclosure, the first color filter unit light-shielding layer 267 is arranged on the peripheral edge of the pixel array unit 10, so that the reflection of the incident light may be reduced and the deterioration in image quality may be prevented.

Note that the technology applied to the third to eighth embodiments of the present disclosure may be applied to the pixel array unit 10 of the first and second embodiments of the present disclosure. Similarly, the technology applied to the first and second embodiments of the present disclosure may be applied to the pixel array unit 10 of the third to eighth embodiments of the present disclosure.

### <9. Application Example to Stacked Solid-state Imaging Device>

The technology according to the present disclosure (present technology) may also be applied to a stacked solid-state imaging device. That is, the imaging element described with reference to Figs. 1 to 19 may also be formed as a stacked solid-state imaging element.

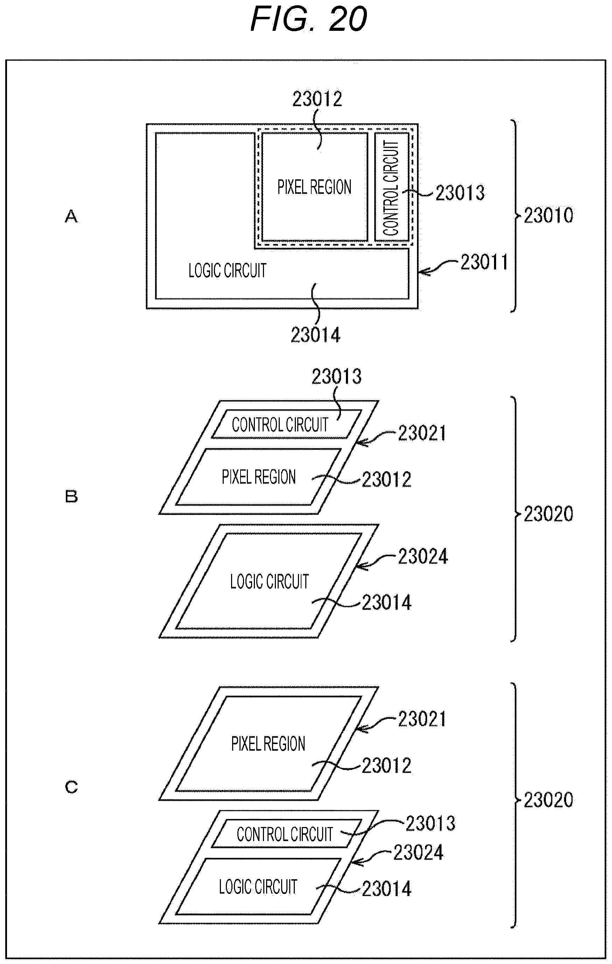

Fig. 20 is a view illustrating an outline of a configuration example of a stacked solid-state imaging device to which the technology according to the present disclosure is applicable.

A of Fig. 20 illustrates a schematic configuration example of a non-stacked solid-state imaging device. A solid-state imaging device 23010 includes one die (semiconductor substrate) 23011 as illustrated in A of Fig. 20. The die 23011 is equipped with a pixel region 23012 in which pixels are arranged into an array, a control circuit 23013 that drives the pixels and performs other various controls, and a logic circuit 23014 for performing signal processing.

B and C of Fig. 20 illustrate schematic configuration examples of the stacked solid-state imaging device. As illustrated in B and C of Fig. 20, a solid-state imaging device 23020 is formed as one semiconductor chip by stacking two dies of a sensor die 23021 and a logic die 23024 and electrically connecting them.

In B of Fig. 20, the sensor die 23021 is equipped with a pixel region 23012 and a control circuit 23013, and the logic die 23024 is equipped with a logic circuit 23014 including a signal processing circuit for performing signal processing.

In C of Fig. 20, the sensor die 23021 is equipped with the pixel region 23012, and the logic die 23024 is equipped with the control circuit 23013 and the logic circuit 23014.

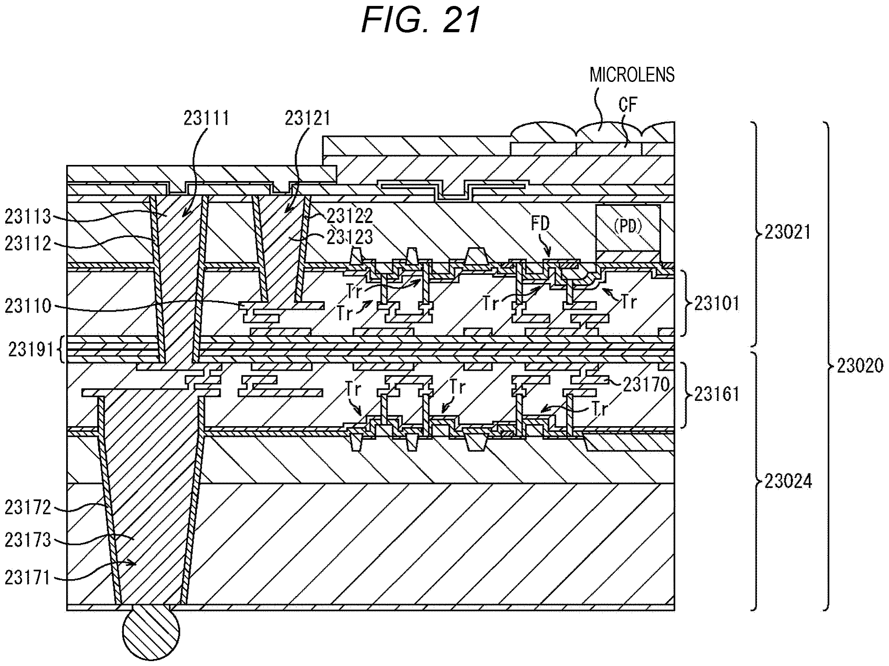

Fig. 21 is a cross-sectional view illustrating a first configuration example of the stacked solid-state imaging device 23020.

In the sensor die 23021, a photodiode (PD), a floating diffusion (FD), a Tr (MOS FET) that form a pixel serving as the pixel region 23012, a Tr serving as the control circuit 23013 and the like are formed. Moreover, a wiring layer 23101 including a plurality of (in this example, three) layers of wiring 23110 is formed in the sensor die 23021. Note that, (Tr that serves as) the control circuit 23013 may be formed not in the sensor die 23021 but in the logic die 23024.

In the logic die 23024, Tr forming the logic circuit 23014 is formed. Moreover, a wiring layer 23161 including a plurality of (in this example, three) layers of wiring 23170 is formed in the logic die 23024. Furthermore, in the logic die 23024, a connection hole 23171 having an insulating film 23172 formed on an inner wall surface thereof is formed, and a connection conductor 23173 connected to the wiring 23170 and the like is embedded in the connection hole 23171.

The sensor die 23021 and the logic die 23024 are bonded to each other so that the wiring layers 23101 and 23161 face each other, thereby forming the stacked solid-state imaging device 23020 in which the sensor die 23021 and the logic die 23024 are stacked. A film 23191 such as a protective film is formed on a surface on which the sensor die 23021 and the logic die 23024 are bonded to each other.

In the sensor die 23021, a connection hole 23111 is formed that penetrates the sensor die 23021 from a back surface side (side on which light is incident on PD) (upper side) of the sensor die 23021 to reach the wiring 23170 in an uppermost layer of the logic die 23024. Moreover, a connection hole 23121 is formed in proximity to the connection hole 23111 in the sensor die 23021 so as to reach the first-layer wiring 23110 from the back surface side of the sensor die 23021. An insulating film 23112 is formed on an inner wall surface of the connection hole 23111, and an insulating film 23122 is formed on an inner wall surface of the connection hole 23121. Then, connection conductors 23113 and 23123 are embedded in the connection holes 23111 and 23121, respectively. The connection conductor 23113 and the connection conductor 23123 are electrically connected to each other on the back surface side of the sensor die 23021, therefore the sensor die 23021 and the logic die 23024 are electrically connected to each other via the wiring layer 23101, the connection hole 23121, the connection hole 23111, and the wiring layer 23161.

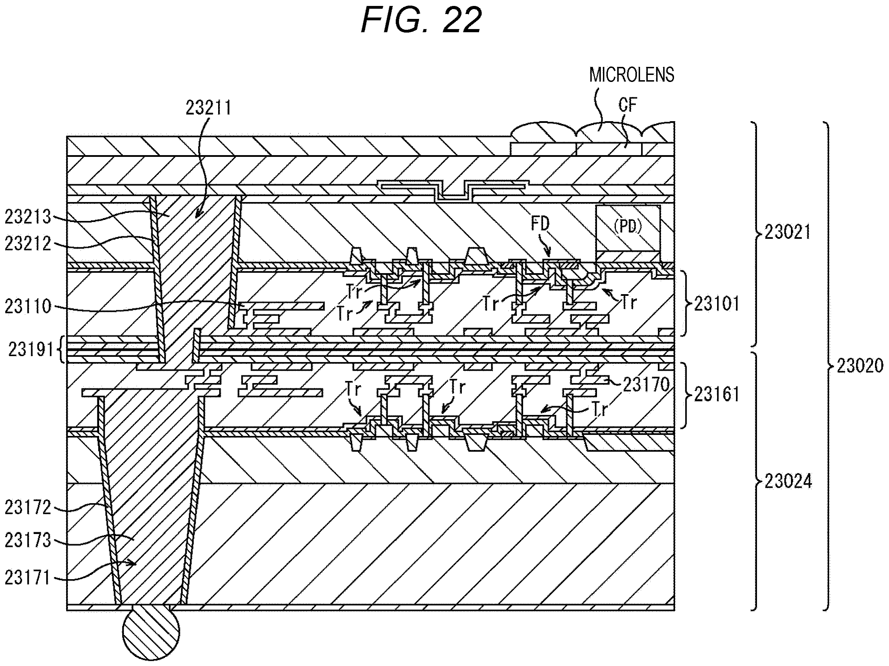

Fig. 22 is a cross-sectional view illustrating a second configuration example of the stacked solid-state imaging device 23020.

In the second configuration example of the solid-state imaging device 23020, ((the wiring 23110 of) the wiring layer 23101 of) the sensor die 23021 and ((the wiring 23170 of) the wiring layer 23161 of) the logic die 23024 are electrically connected to each other through one connection hole 23211 formed in the sensor die 23021.

That is, in Fig. 22, the connection hole 23211 is formed so as to penetrate the sensor die 23021 from the back surface side of the sensor die 23021 to reach the wiring 23170 in the uppermost layer of the logic die 23024 and reach the wiring 23110 in the uppermost layer of the sensor die 23021. An insulating film 23212 is formed on an inner wall surface of the connection hole 23211, and a connection conductor 23213 is embedded in the connection hole 23211. In Fig. 21 described above, the sensor die 23021 and the logic die 23024 are electrically connected to each other by the two connection holes 23111 and 23121, but in Fig. 22, the sensor die 23021 and the logic die 23024 are electrically connected to each other by one connection hole 23211.

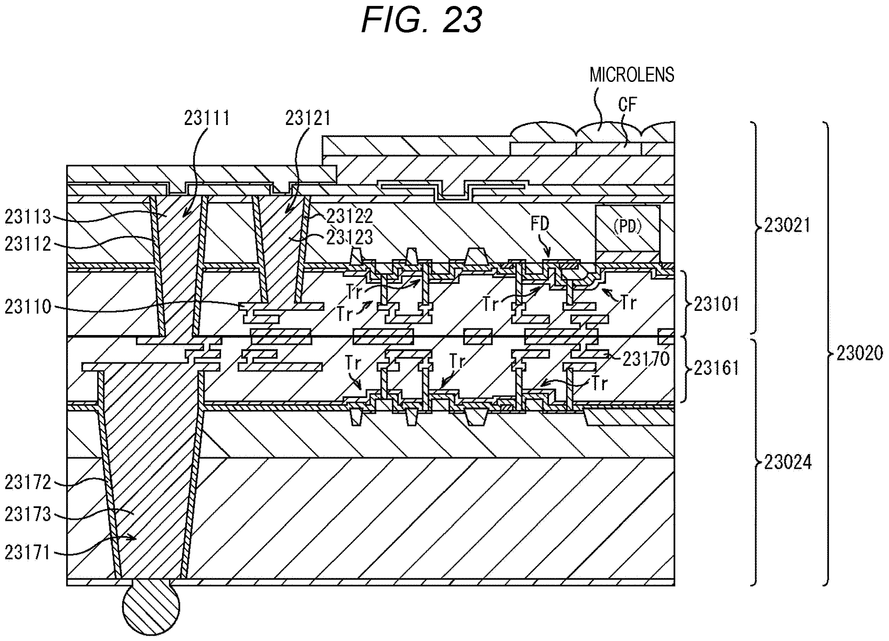

Fig. 23 is a cross-sectional view illustrating a third configuration example of the stacked solid-state imaging device 23020.

The solid-state imaging device 23020 in Fig. 23 is different from a case in Fig. 21 in which the film 23191 such as the protective film is formed on the surface on which the sensor die 23021 and the logic die 23024 are bonded to each other in that the film 23191 such as the protective film is not formed on the surface on which the sensor die 23021 and the logic die 23024 are bonded to each other.

The solid-state imaging device 23020 in Fig. 23 is formed by overlapping the sensor die 23021 and the logic die 23024 such that the wiring 23110 and the wiring 23170 are brought into direct contact with each other, and heating them while applying a required weight to directly join the wiring 23110 and the wiring 23170.

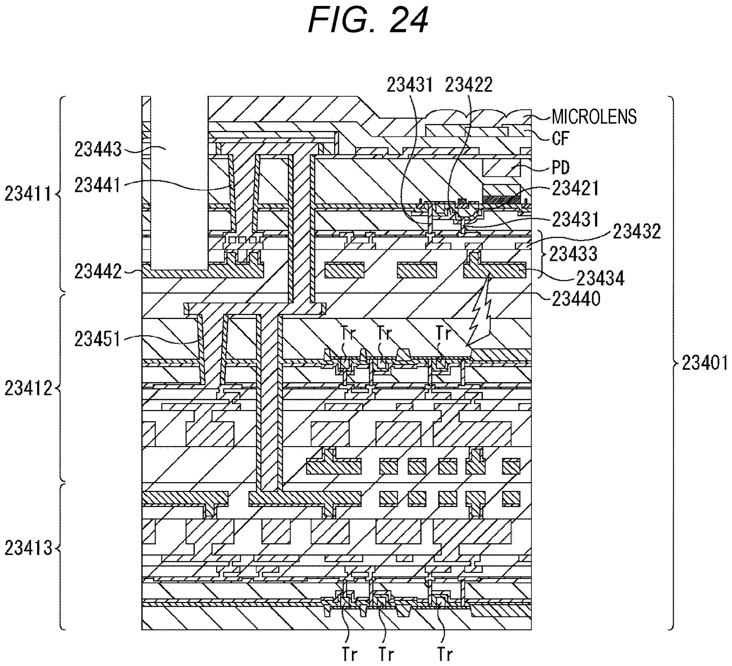

Fig. 24 is a cross-sectional view illustrating another configuration example of a stacked solid-state imaging device to which the technology according to the present disclosure is applicable.

In Fig. 24, a solid-state imaging device 23401 has a three-layer stacked structure in which three dies including a sensor die 23411, a logic die 23412, and a memory die 23413 are stacked.

The memory die 23413 includes, for example, a memory circuit that stores data temporarily required in signal processing performed by the logic die 23412.

In Fig. 24, the logic die 23412 and the memory die 23413 are stacked in this order under the sensor die 23411, but the logic die 23412 and the memory die 23413 may be stacked under the sensor die 23411 in reverse order, that is, in order of the memory die 23413 and the logic die 23412.

Note that, in Fig. 24, in the sensor die 23411, a PD serving as a photoelectric conversion unit of a pixel and source/drain regions of a pixel Tr are formed.

A gate electrode is formed around the PD via a gate insulating film, and a pixel Tr 23421 and a pixel Tr 23422 are formed by the gate electrode and a pair of source/drain regions.

The pixel Tr 23421 adjacent to the PD is a transfer Tr, and one of the pair of source/drain regions forming the pixel Tr 23421 is a FD.

Furthermore, an interlayer insulating film is formed in the sensor die 23411, and a connection hole is formed in the interlayer insulating film. In the connection hole, a connection conductor 23431 connected to the pixel Tr 23421 and the pixel Tr 23422 is formed.

Moreover, a wiring layer 23433 including a plurality of layers of wiring 23432 connected to each connection conductor 23431 is formed in the sensor die 23411.

Furthermore, an aluminum pad 23434 serving as an electrode for external connection is formed in a lowermost layer of the wiring layer 23433 of the sensor die 23411. That is, in the sensor die 23411, the aluminum pad 23434 is formed in a position closer to a bonding surface 23440 with the logic die 23412 than the wiring 23432. The aluminum pad 23434 is used as one end of wiring regarding external input/output of a signal.

Moreover, a contact 23441 used for electrical connection to the logic die 23412 is formed in the sensor die 23411. The contact 23441 is connected to a contact 23451 of the logic die 23412 and also to an aluminum pad 23442 of the sensor die 23411.

Then, a pad hole 23443 is formed in the sensor die 23411 so as to reach the aluminum pad 23442 from the back surface side (upper side) of the sensor die 23411.

The technology according to the present disclosure may be applied to the solid-state imaging device as described above.

### <10. Application Example to Camera>

The technology according to the present disclosure (present technology) may be applied to various products. For example, the present technology may be realized as an imaging element mounted on an imaging device such as a camera.

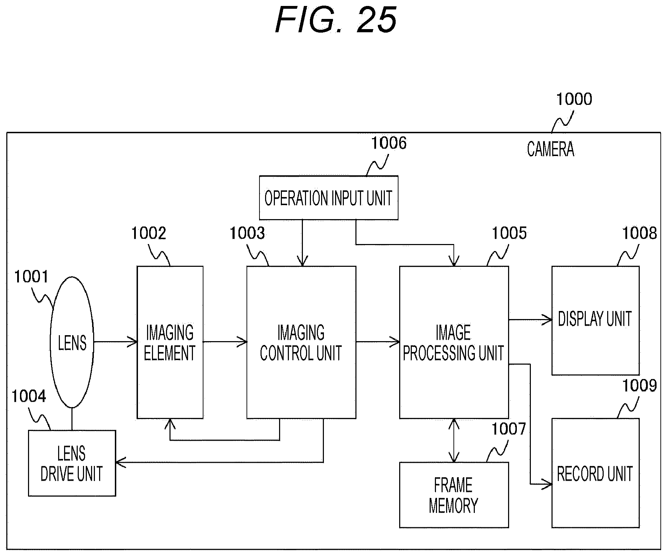

Fig. 25 is a block diagram illustrating a schematic configuration example of a camera that is an example of an imaging device to which the present technology may be applied. A camera 1000 in the drawing is provided with a lens 1001, an imaging element 1002, an imaging control unit 1003, a lens drive unit 1004, an image processing unit 1005, an operation input unit 1006, a frame memory 1007, a display unit 1008, and a record unit 1009.

The lens 1001 is an imaging lens of the camera 1000. The lens 1001 condenses light from a subject and allows the same to be incident on the imaging element 1002 to be described later to form an image of the subject.

The imaging element 1002 is a semiconductor element that images the light from the subject condensed by the lens 1001. The imaging element 1002 generates an analog image signal corresponding to applied light and converts the same into a digital image signal to output.

The imaging control unit 1003 controls imaging by the imaging element 1002. The imaging control unit 1003 controls the imaging element 1002 by generating a control signal and outputting the same to the imaging element 1002. Furthermore, the imaging control unit 1003 may perform autofocus in the camera 1000 on the basis of the image signal output from the imaging element 1002. Here, the autofocus is a system that detects a focal position of the lens 1001 to automatically adjust. As the autofocus, a method of detecting the focal position by detecting an image plane phase difference by a phase difference pixel arranged in the imaging element 1002 (image plane phase difference autofocus) may be used. Furthermore, a method of detecting a position in which contrast of an image is the highest as the focal position (contrast autofocus) may also be applied. The imaging control unit

1003 adjusts a position of the lens 1001 via the lens drive unit 1004 on the basis of the detected focal position and performs the autofocus. Note that the imaging control unit 1003 may be formed by using, for example, a digital signal processor (DSP) equipped with firmware.

The lens drive unit 1004 drives the lens 1001 on the basis of control of the imaging control unit 1003. The lens drive unit 1004 may drive the lens 1001 by changing the position of the lens 1001 using a built-in motor.

The image processing unit 1005 processes the image signal generated by the imaging element 1002. This processing includes, for example, demosaicing of generating an image signal of a lacking color among the image signals corresponding to red, green, and blue for each pixel, noise reduction of removing noise of the image signal, encoding of the image signal and the like. The image processing unit 1005 may be formed by using, for example, a microcomputer equipped with firmware.

The operation input unit 1006 receives an operation input from a user of the camera 1000. As the operation input unit 1006, for example, a push button or a touch panel may be used. The operation input received by the operation input unit 1006 is transmitted to the imaging control unit 1003 and the image processing unit 1005. Thereafter, processing according to the operation input, for example, processing such as imaging of the subject is started.

The frame memory 1007 is a memory that stores a frame being the image signal for one screen. The frame memory 1007 is controlled by the image processing unit 1005 and holds the frame in the course of the image processing.

The display unit 1008 displays an image processed by the image processing unit 1005. As the display unit 1008, for example, a liquid crystal panel may be used.

The record unit 1009 records the image processed by the image processing unit 1005. As the record unit 1009, for example, a memory card or a hard disk may be used.

The camera to which the present disclosure may be applied is described above. The present technology may be applied to the imaging element 1002 among the configurations described above. Specifically, the imaging device 1 illustrated in Fig. 1 may be applied to the imaging element 1002.

Note that, the camera is herein described as an example, but the technology according to the present disclosure may be applied to, for example, a monitoring device and the like in addition to this. Furthermore, the present disclosure may be applied to a semiconductor device in a form of a semiconductor module in addition to an electronic device such as a camera. Specifically, the technology according to the present disclosure may be applied to an imaging module being a semiconductor module in which the imaging element 1002 and the imaging control unit 1003 in Fig. 25 are enclosed in one package.

### <11. Application Example to Endoscopic Surgery System>

The technology according to the present disclosure is applicable to various products. For example, the technology according to the present disclosure may be applied to an endoscopic surgery system.

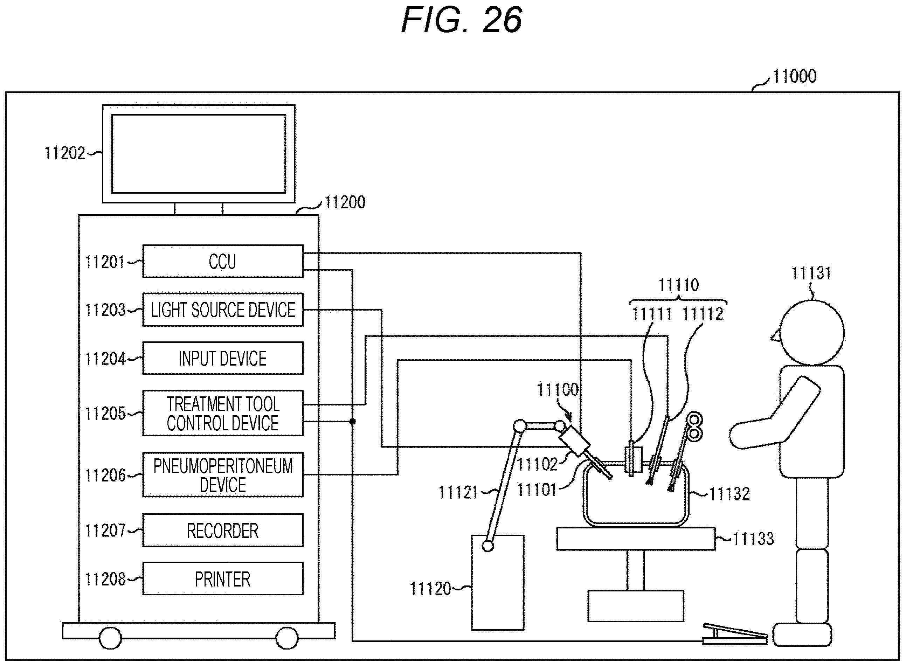

Fig. 26 is a view illustrating an example of a schematic configuration of the endoscopic surgery system to which the technology according to the present disclosure may be applied.

Fig. 26 illustrates a state in which an operator (surgeon) 11131 performs surgery on a patient 11132 on a patient bed 11133 by using an endoscopic surgery system 11000. As illustrated, the endoscopic surgery system 11000 includes an endoscope 11100, other surgical tools 11110 such as a pneumoperitoneum tube 11111 and an energy treatment tool 11112, a support arm device 11120 that supports the endoscope 11100, and a cart 11200 on which various devices for endoscopic surgery are mounted.

The endoscope 11100 includes a lens tube 11101 a region of a predetermined length from a distal end of which is inserted into a body cavity of the patient 11132 and a camera head 11102 connected to a proximal end of the lens tube 11101. In the illustrated example, the endoscope 11100 formed as a so-called rigid scope including a rigid lens tube 11101 is illustrated, but the endoscope 11100 may also be formed as a so-called flexible scope including a flexible lens tube.

At a distal end of the lens tube 11101, an opening into which an objective lens is fitted is provided. A light source device 11203 is connected to the endoscope 11100 and light generated by the light source device 11203 is guided to the distal end of the lens tube by a light guide extending inside the lens tube 11101, and applied to an observation target in the body cavity of the patient 11132 via the objective lens. Note that the endoscope 11100 may be a forward-viewing endoscope, an oblique-viewing endoscope, or a side-viewing endoscope.

An optical system and an imaging element are provided inside the camera head 11102, and reflected light (observation light) from the observation target is condensed on the imaging element by the optical system. The observation light is photoelectrically converted by the imaging element, and an electric signal corresponding to the observation light, that is, an image signal corresponding to an observation image is generated. The image signal is transmitted as RAW data to a camera control unit (CCU) 11201.

The CCU 11201 is formed by a central processing unit (CPU), a graphics processing unit (GPU) and the like, and comprehensively controls operation of the endoscope 11100 and a display device 11202. Moreover, the CCU 11201 receives the image signal from the camera head 11102 and applies various types of image processing for displaying an image based on the image signal such as, for example, development processing (demosaic processing) on the image signal.

The display device 11202 displays the image based on the image signal subjected to the image processing by the CCU 11201 under the control of the CCU 11201.

The light source device 11203 includes a light source such as, for example, a light emitting diode (LED), and supplies the endoscope 11100 with irradiation light when imaging a surgical site and the like.

An input device 11204 is an input interface to the endoscopic surgery system 11000. A user may input various types of information and instructions to the endoscopic surgery system 11000 via the input device 11204. For example, the user inputs an instruction and the like to change an imaging condition (type of irradiation light, magnification, focal length and the like) by the endoscope 11100.

A treatment tool control device 11205 controls drive of the energy treatment tool 11112 for tissue cauterization, incision, blood vessel sealing or the like. A pneumoperitoneum device 11206 injects gas into the body cavity via the pneumoperitoneum tube 11111 to inflate the body cavity of the patient 11132 for the purpose of securing a visual field by the endoscope 11100 and securing a working space of the operator. A recorder 11207 is a device capable of recording various types of information regarding surgery. A printer 11208 is a device capable of printing various types of information regarding surgery in various formats such as text, image, or graph.

Note that the light source device 11203 that supplies the irradiation light when imaging the surgical site to the endoscope 11100 may include, for example, an LED, a laser light source, or a white light source obtained by combining them. Since output intensity and output timing of each color (each wavelength) may be controlled with a high degree of accuracy in a case where the white light source is formed by the combination of RGB laser light sources, the light source device 11203 may adjust white balance of the taken image. Furthermore, in this case, by irradiating the observation target with laser light from each of the RGB laser light sources in time division manner and controlling the drive of the imaging element of the camera head 11102 in synchronization with the irradiation timing, it is also possible to take images corresponding to RGB in a time division manner. According to this method, a color image may be obtained without providing a color filter on the imaging element.

Furthermore, drive of the light source device 11203 may be controlled such that the intensity of light to be output is changed every predetermined time. By controlling drive of the imaging element of the camera head 11102 in synchronization with the timing of the change of the light intensity to obtain images in a time division manner and combining the images, an image of a high dynamic range without so-called black defect and halation may be generated.

Furthermore, the light source device 11203 may supply light of a predetermined wavelength band corresponding to special light observation. In the special light observation, for example, by applying light of a narrower band than that of the irradiation light at ordinary observation (in other words, white light) by utilizing wavelength dependency of absorption of light in the body tissue, so-called narrow band imaging is performed in which predetermined tissue such as the blood vessel in the mucosal surface layer is imaged with high contrast. Alternatively, in the special light observation, fluorescent observation for obtaining an image by fluorescence generated by irradiation of excitation light may be performed. In the fluorescent observation, it is possible to irradiate the body tissue with excitation light to observe fluorescence from the body tissue (autonomous fluorescent observation) or to locally inject a reagent such as indocyanine green (ICG) to the body tissue and irradiate the body tissue with excitation light corresponding to a fluorescent wavelength of the reagent, thereby obtaining a fluorescent image, for example. The light source device 11203 may supply the narrow band light and/or excitation light corresponding to such special light observation.

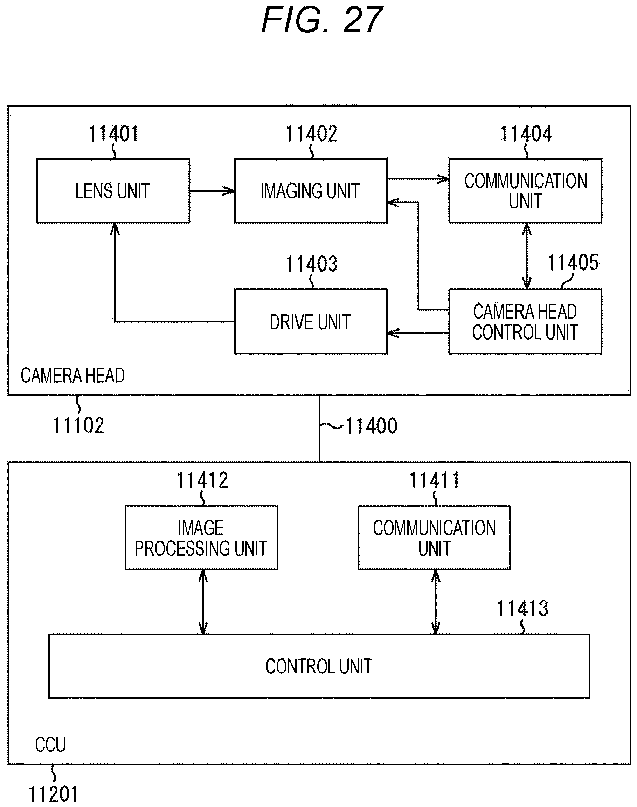

Fig. 27 is a block diagram illustrating an example of functional configurations of the camera head 11102 and the CCU 11201 illustrated in Fig. 26.

The camera head 11102 includes a lens unit 11401, an imaging unit 11402, a drive unit 11403, a communication unit 11404, and a camera head control unit 11405. The CCU 11201 includes a communication unit 11411, an image processing unit 11412, and a control unit 11413. The camera head 11102 and the CCU 11201 are connected to each other so as to be able to communicate by a transmission cable 11400.

The lens unit 11401 is an optical system provided at a connection to the lens tube 11101. The observation light taken in from the distal end of the lens tube 11101 is guided to the camera head 11102 and is incident on the lens unit 11401. The lens unit 11401 is formed by combining a plurality of lenses including a zoom lens and a focus lens.

The imaging unit 11402 includes an imaging element. The imaging element forming the imaging unit 11402 may be one imaging element (a so-called single plate type) or a plurality of imaging elements (a so-called multiple plate type). In a case where the imaging unit 11402 is of the multiple plate type, for example, the image signals corresponding to RGB may be generated by the respective imaging elements, and a color image may be obtained by combining them. Alternatively, the imaging unit 11402 may include a pair of imaging elements for obtaining right-eye and left-eye image signals corresponding to three-dimensional (3D) display. By the 3D display, the operator 11131 may grasp a depth of the living tissue in the surgical site more accurately. Note that, in a case where the imaging unit 11402 is of the multiple plate type, a plurality of systems of lens units 11401 may be provided so as to correspond to the respective imaging elements.

Furthermore, the imaging unit 11402 is not necessarily provided on the camera head 11102. For example, the imaging unit 11402 may be provided inside the lens tube 11101 immediately after the objective lens.

The drive unit 11403 includes an actuator and moves the zoom lens and the focus lens of the lens unit 11401 by a predetermined distance along an optical axis under the control of the camera head control unit 11405. Therefore, the magnification and focal point of the image taken by the imaging unit 11402 may be appropriately adjusted.

The communication unit 11404 includes a communication device for transmitting and receiving various types of information to and from the CCU 11201. The communication unit 11404 transmits the image signal obtained from the imaging unit 11402 as the RAW data to the CCU 11201 via the transmission cable 11400.

Furthermore, the communication unit 11404 receives a control signal for controlling drive of the camera head 11102 from the CCU 11201 and supplies the same to the camera head control unit 11405. The control signal includes, for example, information regarding imaging conditions such as information specifying a frame rate of the taken image, information specifying an exposure value at the time of imaging, and/or information specifying the magnification and focal point of the taken image.

Note that, the imaging conditions such as the frame rate, exposure value, magnification, and focal point described above may be appropriately specified by the user or automatically set by the control unit 11413 of the CCU 11201 on the basis of the obtained image signal. In the latter case, the endoscope 11100 has a so-called auto exposure (AE) function, an autofocus (AF) function, and an auto white balance (AWB) function.

The camera head control unit 11405 controls the drive of the camera head 11102 on the basis of the control signal from the CCU 11201 received via the communication unit 11404.

The communication unit 11411 includes a communication device for transmitting and receiving various types of information to and from the camera head 11102. The communication unit 11411 receives the image signal transmitted from the camera head 11102 via the transmission cable 11400.

Furthermore, the communication unit 11411 transmits the control signal for controlling the drive of the camera head 11102 to the camera head 11102. The image signal and the control signal may be transmitted by electric communication, optical communication and the like.

The image processing unit 11412 performs various types of image processing on the image signal being the RAW data transmitted from the camera head 11102.

The control unit 11413 performs various types of control regarding imaging of the surgical site and the like by the endoscope 11100 and display of the taken image obtained by imaging the surgical site and the like. For example, the control unit 11413 generates the control signal for controlling the drive of the camera head 11102.

Furthermore, the control unit 11413 allows the display device 11202 to display the taken image of the surgical site and the like on the basis of the image signal subjected to the image processing by the image processing unit 11412. At that time, the control unit 11413 may recognize various objects in the taken image using various image recognition technologies. For example, the control unit 11413 may detect a shape, a color and the like of an edge of the object included in the taken image, thereby recognizing a surgical tool such as forceps, a specific living-body site, bleeding, mist when using the energy treatment tool 11112 and the like. When allowing the display device 11202 to display the taken image, the control unit 11413 may superimpose to display various types of surgery support information on the image of the surgical site using a recognition result. The surgery support information is superimposed to be displayed, and presented to the operator 11131, so that a burden on the operator 11131 may be reduced and the operator 11131 may reliably proceed with surgery.

The transmission cable 11400 connecting the camera head 11102 and the CCU 11201 is an electric signal cable supporting communication of electric signals, an optical fiber supporting optical communication, or a composite cable thereof.

Here, in the illustrated example, the communication is performed by wire using the transmission cable 11400, but the communication between the camera head 11102 and the CCU 11201 may be performed wirelessly.

An example of the endoscopic surgery system to which the technology according to the present disclosure may be applied is described above. The technology according to the present disclosure may be applied to the imaging unit 11402 of the camera head 11102 out of the configurations described above. Specifically, the imaging device 1 illustrated in Fig. 1 may be applied to the imaging unit 10402.

Note that, the endoscopic surgery system is herein described as an example, but in addition to this, the technology according to the present disclosure may also be applied to a microscopic surgery system and the like, for example.

### <12. Application Example to Mobile Body>

The technology according to the present disclosure is applicable to various products. For example, the technology according to the present disclosure may also be realized as a device mounted on any type of mobile body such as an automobile, an electric automobile, a hybrid electric automobile, a motorcycle, a bicycle, a personal mobility, an airplane, a drone, a ship, and a robot.

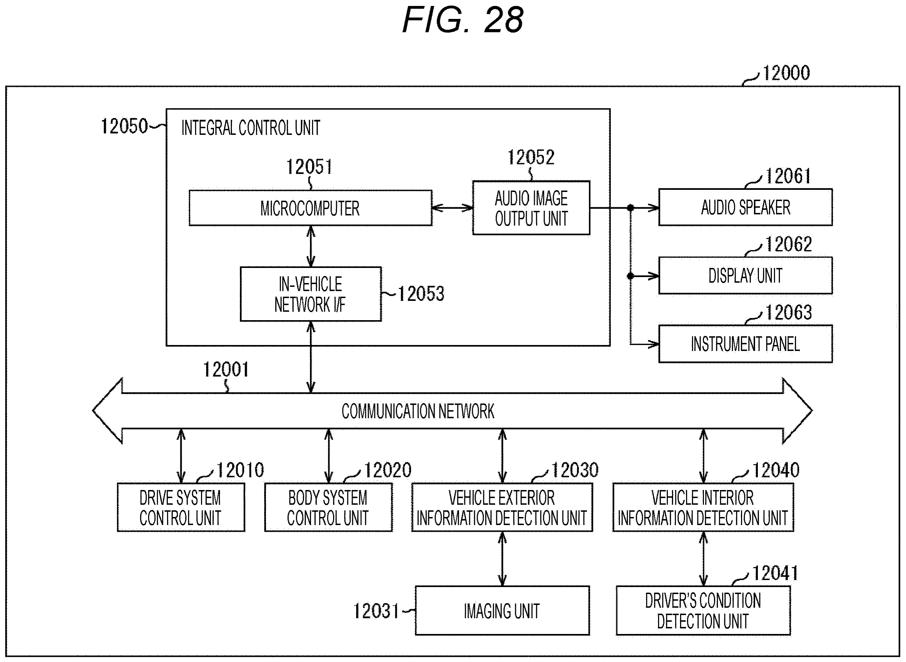

Fig. 28 is a block diagram illustrating a schematic configuration example of a vehicle control system being an example of a mobile body control system to which the technology according to the present disclosure is applicable.

A vehicle control system 12000 is provided with a plurality of electronic control units connected to one another via a communication network 12001. In the example illustrated in Fig. 28, the vehicle control system 12000 is provided with a drive system control unit 12010, a body system control unit 12020, a vehicle exterior information detection unit 12030, a vehicle interior information detection unit 12040, and an integrated control unit 12050. Furthermore, a microcomputer 12051, an audio image output unit 12052, and an in-vehicle network interface (I/F) 12053 are illustrated as functional configurations of the integrated control unit 12050.

The drive system control unit 12010 controls operation of devices related to a drive system of a vehicle according to various programs. For example, the drive system control unit 12010 serves as a control device of a driving force generating device for generating driving force of the vehicle such as an internal combustion engine or a driving motor, a driving force transmitting mechanism for transmitting the driving force to wheels, a steering mechanism for adjusting a rudder angle of the vehicle, a braking device for generating braking force of the vehicle and the like.

The body system control unit 12020 controls operation of various devices mounted on a vehicle body according to the various programs. For example, the body system control unit 12020 serves as a control device of a keyless entry system, a smart key system, a power window device, or various lights such as a head light, a backing light, a brake light, a blinker, or a fog light. In this case, a radio wave transmitted from a portable device that substitutes for a key or signals of various switches may be input to the body system control unit 12020. The body system control unit 12020 receives an input of the radio wave or signals and controls a door lock device, a power window device, the lights and the like of the vehicle.

The vehicle exterior information detection unit 12030 detects information outside the vehicle equipped with the vehicle control system 12000. For example, an imaging unit 12031 is connected to the vehicle exterior information detection unit 12030. The vehicle exterior information detection unit 12030 allows the imaging unit 12031 to take an image of the exterior of the vehicle and receives taken image data. The vehicle exterior information detection unit 12030 may perform detection processing of objects such as a person, a vehicle, an obstacle, a sign, or a character on a road surface or distance detection processing on the basis of the received image.

The imaging unit 12031 is an optical sensor that receives light and outputs an electric signal corresponding to an amount of the received light. The imaging unit 12031 may output the electric signal as the image or output the same as ranging information. Furthermore, the light received by the imaging unit 12031 may be visible light or invisible light such as infrared light.

The vehicle interior information detection unit 12040 detects information in the vehicle. The vehicle interior information detection unit 12040 is connected to, for example, a driver's condition detection unit 12041 for detecting a driver's condition. The driver's condition detection unit 12041 includes, for example, a camera that images the driver, and the vehicle interior information detection unit 12040 may calculate a driver's fatigue level or concentration level or may determine whether or not the driver is dozing on the basis of detection information input from the driver's condition detection unit 12041.

The microcomputer 12051 may calculate a control target value of the driving force generating device, the steering mechanism, or the braking device on the basis of the information inside and outside the vehicle obtained by the vehicle exterior information detection unit 12030 or the vehicle interior information detection unit 12040, and output a control instruction to the drive system control unit 12010. For example, the microcomputer 12051 may perform cooperative control for realizing functions of advanced driver assistance system (ADAS) including collision avoidance or impact attenuation of the vehicle, following travel based on the distance between the vehicles, vehicle speed maintaining travel, vehicle collision warning, vehicle lane departure warning and the like.

Furthermore, the microcomputer 12051 may perform the cooperative control for realizing automatic driving and the like to autonomously travel independent from the operation of the driver by controlling the driving force generating device, the steering mechanism, the braking device or the like on the basis of the information around the vehicle obtained by the vehicle exterior information detection unit 12030 or the vehicle interior information detection unit 12040.

Furthermore, the microcomputer 12051 may output the control instruction to the body system control unit 12020 on the basis of the information outside the vehicle obtained by the vehicle exterior information detection unit 12030. For example, the microcomputer 12051 may perform the cooperative control for realizing glare protection such as controlling the head light according to a position of a preceding vehicle or an oncoming vehicle detected by the vehicle exterior information detection unit 12030 to switch a high beam to a low beam.

The audio image output unit 12052 transmits at least one of audio or image output signal to an output device capable of visually or audibly notifying an occupant of the vehicle or the outside the vehicle of the information. In the example in Fig. 28, as the output device, an audio speaker 12061, a display unit 12062, and an instrument panel 12063 are illustrated. The display unit 12062 may include at least one of an on-board display or a head-up display, for example.

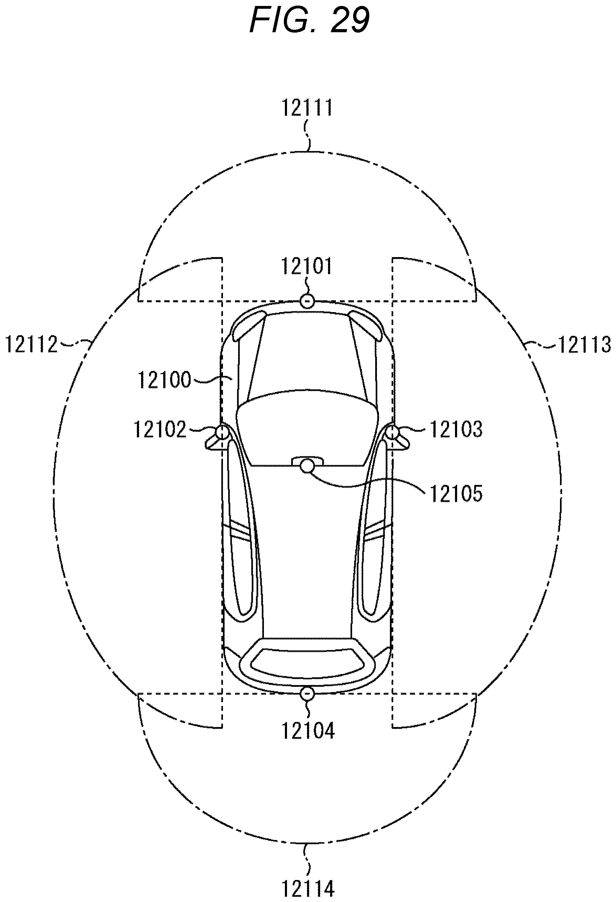

Fig. 29 is a view illustrating an example of an installation position of the imaging unit 12031.

In Fig. 29, the vehicle 12100 includes imaging units 12101, 12102, 12103, 12104, and 12105 as the imaging unit 12031.

The imaging units 12101, 12102, 12103, 12104, and 12105 are provided in positions such as, for example, a front nose, a side mirror, a rear bumper, a rear door, and an upper portion of a front windshield in a vehicle interior of the vehicle 12100. The imaging unit 12101 provided on the front nose and the imaging unit 12105 provided in the upper portion of the front windshield in the vehicle interior principally obtain images in front of the vehicle 12100. The imaging units 12102 and 12103 provided on the side mirrors principally obtain images of the sides of the vehicle 12100. The imaging unit 12104 provided on the rear bumper or the rear door principally obtains an image behind the vehicle 12100. The images in front obtained by the imaging units 12101 and 12105 are principally used for detecting a preceding vehicle, or a pedestrian, an obstacle, a traffic signal, a traffic sign, a lane or the like.

Note that, in Fig. 29, an example of imaging ranges of the imaging units 12101 to 12104 is illustrated. An imaging range 12111 indicates the imaging range of the imaging unit 12101 provided on the front nose, imaging ranges 12112 and 12113 indicate the imaging ranges of the imaging units 12102 and 12103 provided on the side mirrors, and an imaging range 12114 indicates the imaging range of the imaging unit 12104 provided on the rear bumper or the rear door. For example, image data taken by the imaging units 12101 to 12104 are superimposed, so that an overhead image of the vehicle 12100 as seen from above is obtained.

At least one of the imaging units 12101 to 12104 may have a function of obtaining distance information. For example, at least one of the imaging units 12101 to 12104 may be a stereo camera including a plurality of imaging elements, or may be an imaging element including pixels for phase difference detection.

For example, the microcomputer 12051 may extract especially a closest solid object on a traveling path of the vehicle 12100, the solid object traveling at a predetermined speed (for example, 0 km/h or higher) in a direction substantially the same as that of the vehicle 12100 as the preceding vehicle by obtaining a distance to each solid object in the imaging ranges 12111 to 12114 and a change in time of the distance (relative speed relative to the vehicle 12100) on the basis of the distance information obtained from the imaging units 12101 to 12104. Moreover, the microcomputer 12051 may set the distance between the vehicles to be secured in advance from the preceding vehicle, and may perform automatic brake control (including following stop control), automatic acceleration control (including following start control) and the like. In this manner, it is possible to perform the cooperative control for realizing the automatic driving and the like to autonomously travel independent from the operation of the driver.

For example, the microcomputer 12051 may extract solid object data regarding the solid object while sorting the same into a motorcycle, a standard vehicle, a large-sized vehicle, a pedestrian, and other solid objects such as a utility pole on the basis of the distance information obtained from the imaging units 12101 to 12104 and use for automatically avoiding obstacles. For example, the microcomputer 12051 discriminates the obstacles around the vehicle 12100 into an obstacle visible to a driver of the vehicle 12100 and an obstacle difficult to see. Then, the microcomputer 12051 determines a collision risk indicating a degree of risk of collision with each obstacle, and when the collision risk is equal to or higher than a set value and there is a possibility of collision, this may perform driving assistance for avoiding the collision by outputting an alarm to the driver via the audio speaker 12061 and the display unit 12062 or performing forced deceleration or avoidance steering via the drive system control unit 12010.

At least one of the imaging units 12101 to 12104 may be an infrared camera for detecting infrared rays. For example, the microcomputer 12051 may recognize a pedestrian by determining whether or not there is a pedestrian in the images taken by the imaging units 12101 to 12104. Such pedestrian recognition is carried out, for example, by a procedure of extracting feature points in the images taken by the imaging units 12101 to 12104 as the infrared cameras and a procedure of performing pattern matching processing on a series of feature points indicating an outline of an object to discriminate whether or not this is a pedestrian. When the microcomputer 12051 determines that there is a pedestrian in the images taken by the imaging units 12101 to 12104 and recognizes the pedestrian, the audio image output unit 12052 controls the display unit 12062 to superimpose a rectangular contour for emphasis on the recognized pedestrian to display. Furthermore, the audio image output unit 12052 may control the display unit 12062 to display an icon and the like indicating the pedestrian at a desired position.

An example of the vehicle control system to which the technology according to the present disclosure may be applied is described above. The technology according to the present disclosure may be applied to the imaging unit 12031 out of the configurations described above. Specifically, the imaging device 1 illustrated in Fig. 1 may be applied to the imaging unit 12031.

Lastly, the description of each of the above-described embodiments is an example of the present disclosure, and the present disclosure is not limited to the above-described embodiments. For this reason, it goes without saying that, in addition to the embodiments described above, various changes may be made according to a design and the like without departing from the technical idea according to the present disclosure.

Furthermore, the drawings in the above-described embodiments are schematic, and dimensional ratios and the like of the respective units do not necessarily coincide with actual ones. Furthermore, it is needless to say that dimensional relationships and ratios are partly different between the drawings.

Note that the present technology may also have a following configuration.
(1) An imaging element provided with:
   a plurality of pixels in each of which a photoelectric conversion unit that is formed in a semiconductor substrate and photoelectrically converts incident light from a subject is arranged;
   an insulating film that is arranged on the plurality of pixels and insulates the semiconductor substrate;
   an incident light transmitting film that is arranged adjacent to the insulating film of the plurality of pixels and transmits incident light; and
   a light-shielding body that is arranged in a groove formed in the incident light transmitting film on a peripheral edge of each of the plurality of pixels and shields the incident light.
(2) The imaging element according to (1) described above, in which
   the groove is formed by etching the incident light transmitting film.
(3) The imaging element according to (2) described above, in which
   the insulating film is used as a film that stops progress of etching when etching the incident light transmitting film.
(4) The imaging element according to any one of (1) to (3) described above, further provided with:
   a light-shielding film that is arranged adjacent to the incident light transmitting film and shields the incident light.
(5) The imaging element according to (4) described above, in which
   the light-shielding film is arranged on a pixel on a peripheral edge out of the plurality of pixels.
(6) The imaging element according to (4) described above, further provided with:
   a phase difference pixel being a pixel for detecting a phase difference by pupil-splitting the incident light from the subject, in which
   the light-shielding film is arranged on the phase difference pixel and shields a part of the incident light according to a pupil-splitting direction.
(7) The imaging element according to (6) described above, further provided with:
   a second light-shielding body that is arranged in a groove formed in the incident light transmitting film near an end of the light-shielding film and shields diffracted light of the incident light.
(8) The imaging element according to any one of (1) to (7) described above, in which
   the light-shielding body is formed into a tapered shape.
(9) A manufacturing method of an imaging element, provided with:
   a step of forming a photoelectric conversion unit that is arranged for each of a plurality of pixels and photoelectrically converts incident light from a subject in a semiconductor substrate;
   a step of arranging an insulating film that is arranged on the plurality of pixels and insulates the semiconductor substrate;
   a step of arranging an incident light transmitting film that is arranged adjacent to the insulating film of the plurality of pixels and transmits the incident light;
   a step of forming a groove in the incident light transmitting film on a peripheral edge of each of the plurality of pixels; and
   a step of arranging a light-shielding body that shields the incident light in the formed groove.
(10) An imaging element provided with:
   a plurality of pixels in each of which a photoelectric conversion unit that is formed in a semiconductor substrate and photoelectrically converts incident light from a subject is arranged;
   a color filter that is arranged on the plurality of pixels and allows incident light of a predetermined wavelength out of the incident light to be incident on the photoelectric conversion unit;
   a first color filter unit light-shielding layer that is arranged on the plurality of pixels and shields the incident light, the color filter is arranged in an opening formed in a central portion of the first color filter unit light-shielding layer; and
   a second color filter unit light-shielding layer that is arranged on the plurality of pixels and shields the incident light, the color filter is arranged in an opening formed in a central portion of the second color filter unit light-shielding layer, the second color filter unit light-shielding layer arranged between the first color filter unit light-shielding layer and the semiconductor substrate.
(11) The imaging element according to (10) described above, in which
   the first color filter unit light-shielding layer and the second color filter unit light-shielding layer include different materials.
(12) The imaging element according to (11) described above, in which
   the first color filter unit light-shielding layer includes resin, and
   the second color filter unit light-shielding layer includes metal.
(13) The imaging element according to (12) described above, in which
   the first color filter unit light-shielding layer has transmissivity of 30% or lower.
(14) The imaging element according to any one of (10) to (13) described above, further provided with:
   an interlayer film arranged between the first color filter unit light-shielding layer and the second color filter unit light-shielding layer of the plurality of pixels.
(15) The imaging element according to (14) described above, in which
   the interlayer film includes an inorganic material.
(16) The imaging element according to any one of (10) to (15), in which
   the second color filter unit light-shielding layer is formed to have a larger width than a width of the first color filter unit light-shielding layer.
(17) The imaging element according to any one of (10) to (16) described above, further provided with:
   a flattening film that is arranged between the color filter of the plurality of pixels and the semiconductor substrate and flattens a surface of the semiconductor substrate; and
   a light-shielding wall that is arranged around the flattening film on the plurality of pixels and shields the incident light.
(18) The imaging element according to (17) described above, further provided with:
   a second interlayer film arranged between the second color filter unit light-shielding layer and the light-shielding wall of the plurality of pixels.
(19) The imaging element according to (18) described above, in which
   the interlayer film includes an inorganic material.
(20) The imaging element according to any one of (17) to (19 described above, in which
   the second color filter unit light-shielding layer is formed to have a larger width than a width of the light-shielding wall.
(21) The imaging element according to any one of (10) to (20) described above, in which
   at least one of the first color filter unit light-shielding layer or the second color filter unit light-shielding layer in a pixel arranged on a peripheral edge out of the plurality of pixels is formed into a shape to shield light on an entire surface of the pixel.
(22) The imaging element according to any one of (10) to (21) described above, in which
   at least one of the first color filter unit light-shielding layer or the second color filter unit light-shielding layer is formed into a tapered shape.
(23) A manufacturing method of an imaging element, provided with:
   a step of forming a photoelectric conversion unit that is arranged for each of a plurality of pixels and photoelectrically converts incident light from a subject in a semiconductor substrate;
   a step of arranging a second color filter unit light-shielding layer that is arranged on the plurality of pixels and shields the incident light on the semiconductor substrate, a color filter that allows incident light of a predetermined wavelength out of the incident light to be incident on the photoelectric conversion unit is arranged in an opening formed in a central portion of the second color filter unit light-shielding layer;
   a step of stacking and arranging a first color filter unit light-shielding layer that is arranged on the plurality of pixels and shields the incident light on the second color filter unit light-shielding layer, the color filter is arranged in an opening formed in a central portion of the first color filter unit light-shielding layer; and
   a step of arranging the color filter in the opening of each of the second color filter unit light-shielding layer and the first color filter unit light-shielding layer of the plurality of pixels.

### REFERENCE SIGNS LIST

1 Imaging device
10 Pixel array unit
100 Pixel
101 Photoelectric conversion unit
111 Semiconductor substrate
130 Insulating film
141 Incident light transmitting film
142, 342a, 342b, 342c, 342d Light-shielding body
143 Groove
144, 150, 243, 245, 343a, 343b, 346a, 346b Light-shielding film
151 Flattening film
152 Light-shielding wall
160 Color filter
161, 163 Second color filter unit light-shielding layer
162, 164, 167, 267 First color filter unit light-shielding layer
165, 166 Interlayer film
168, 169 Opening
171 On-chip lens
172 Interlayer lens
200 Light-shielding pixel
301, 302 Phase difference pixel
1000 Camera
1002 Imaging element
11402, 12031, 12101 to 12105 Imaging unit

## Claims

1. An imaging element comprising:
a plurality of pixels in each of which a photoelectric conversion unit that is formed in a semiconductor substrate and photoelectrically converts incident light from a subject is arranged;
an insulating film that is arranged on the plurality of pixels and insulates the semiconductor substrate;
an incident light transmitting film that is arranged adjacent to the insulating film of the plurality of pixels and transmits incident light; and
a light-shielding body that is arranged in a groove formed in the incident light transmitting film on a peripheral edge of each of the plurality of pixels and shields the incident light.

2. The imaging element according to claim 1, wherein
the groove is formed by etching the incident light transmitting film.

3. The imaging element according to claim 2, wherein
the insulating film is used as a film that stops progress of etching when etching the incident light transmitting film.

4. The imaging element according to claim 1, further comprising:
a light-shielding film that is arranged adjacent to the incident light transmitting film and shields the incident light.

5. The imaging element according to claim 4, wherein
the light-shielding film is arranged on a pixel on a peripheral edge out of the plurality of pixels.

6. The imaging element according to claim 4, further comprising:
a phase difference pixel being a pixel for detecting a phase difference by pupil-splitting the incident light from the subject, wherein
the light-shielding film is arranged on the phase difference pixel and shields a part of the incident light according to a pupil-splitting direction.

7. The imaging element according to claim 6, further comprising:
a second light-shielding body that is arranged in a groove formed in the incident light transmitting film near an end of the light-shielding film and shields diffracted light of the incident light.

8. The imaging element according to claim 1, wherein
the light-shielding body is formed into a tapered shape.

9. A manufacturing method of an imaging element, comprising:
a step of forming a photoelectric conversion unit that is arranged for each of a plurality of pixels and photoelectrically converts incident light from a subject in a semiconductor substrate;
a step of arranging an insulating film that is arranged on the plurality of pixels and insulates the semiconductor substrate;
a step of arranging an incident light transmitting film that is arranged adjacent to the insulating film of the plurality of pixels and transmits the incident light;
a step of forming a groove in the incident light transmitting film on a peripheral edge of each of the plurality of pixels; and
a step of arranging a light-shielding body that shields the incident light in the formed groove.

10. An imaging element comprising:
a plurality of pixels in each of which a photoelectric conversion unit that is formed in a semiconductor substrate and photoelectrically converts incident light from a subject is arranged;
a color filter that is arranged on the plurality of pixels and allows incident light of a predetermined wavelength out of the incident light to be incident on the photoelectric conversion unit;
a first color filter unit light-shielding layer that is arranged on the plurality of pixels and shields the incident light, the color filter is arranged in an opening formed in a central portion of the first color filter unit light-shielding layer; and
a second color filter unit light-shielding layer that is arranged on the plurality of pixels and shields the incident light, the color filter is arranged in an opening formed in a central portion of the second color filter unit light-shielding layer, the second color filter unit light-shielding layer arranged between the first color filter unit light-shielding layer and the semiconductor substrate.

11. The imaging element according to claim 10, wherein
the first color filter unit light-shielding layer and the second color filter unit light-shielding layer include different materials.

12. The imaging element according to claim 11, wherein
the first color filter unit light-shielding layer includes resin, and
the second color filter unit light-shielding layer includes metal.

13. The imaging element according to claim 12, wherein
the first color filter unit light-shielding layer has transmissivity of 30% or lower.

14. The imaging element according to claim 10, further comprising:
an interlayer film arranged between the first color filter unit light-shielding layer and the second color filter unit light-shielding layer of the plurality of pixels.

15. The imaging element according to claim 14, wherein
the interlayer film includes an inorganic material.

16. The imaging element according to claim 10, wherein
the second color filter unit light-shielding layer is formed to have a larger width than a width of the first color filter unit light-shielding layer.

17. The imaging element according to claim 10, further comprising:
a flattening film that is arranged between the color filter of the plurality of pixels and the semiconductor substrate and flattens a surface of the semiconductor substrate; and
a light-shielding wall that is arranged around the flattening film on the plurality of pixels and shields the incident light.

18. The imaging element according to claim 17, further comprising:
a second interlayer film arranged between the second color filter unit light-shielding layer and the light-shielding wall of the plurality of pixels.

19. The imaging element according to claim 18, wherein
the interlayer film includes an inorganic material.

20. The imaging element according to claim 17, wherein
the second color filter unit light-shielding layer is formed to have a larger width than a width of the light-shielding wall.

21. The imaging element according to claim 10, wherein
at least one of the first color filter unit light-shielding layer or the second color filter unit light-shielding layer in a pixel arranged on a peripheral edge out of the plurality of pixels is formed into a shape to shield light on an entire surface of the pixel.

22. The imaging element according to claim 10, wherein
at least one of the first color filter unit light-shielding layer or the second color filter unit light-shielding layer is formed into a tapered shape.

23. A manufacturing method of an imaging element, comprising:
a step of forming a photoelectric conversion unit that is arranged for each of a plurality of pixels and photoelectrically converts incident light from a subject in a semiconductor substrate;
a step of arranging a second color filter unit light-shielding layer that is arranged on the plurality of pixels and shields the incident light on the semiconductor substrate, a color filter that allows incident light of a predetermined wavelength out of the incident light to be incident on the photoelectric conversion unit is arranged in an opening formed in a central portion of the second color filter unit light-shielding layer;
a step of stacking and arranging a first color filter unit light-shielding layer that is arranged on the plurality of pixels and shields the incident light on the second color filter unit light-shielding layer, the color filter is arranged in an opening formed in a central portion of the first color filter unit light-shielding layer; and
a step of arranging the color filter in the opening of each of the second color filter unit light-shielding layer and the first color filter unit light-shielding layer of the plurality of pixels.
